# EUROPÄISCHE PATENTSCHRIFT

(11) **EP 1 797 462 B1**
(45) Veröffentlichungstag und Bekanntmachung des Hinweises auf die Patenterteilung: **10.01.2018**
(21) Anmeldenummer: 05763129.3
(22) Anmeldetag: 25.07.2005
(51) Int. Cl.: G01V 3/10, H05K 1/16

(54) **SENSOR ZUR ORTUNG METALLISCHER OBJEKTE SOWIE VERFAHREN ZUR AUSWERTUNG VON MESSSIGNALEN EINES SOLCHEN SENSORS**
SENSOR FOR LOCATING METALLIC OBJECTS AND METHOD FOR EVALUATING MEASUREMENT SIGNALS OF A SENSOR OF THIS TYPE
CAPTEUR POUR LOCALISER DES OBJETS METALLIQUES ET METHODE POUR EVALUER LES SIGNAUX DE MESURE D'UN CAPTEUR DE CE TYPE

(30) Priorität: 29.09.2004 DE 102004047189
(43) Veröffentlichungstag der Anmeldung: 20.06.2007
(73) Patentinhaber: ROBERT BOSCH GMBH, 70442 Stuttgart (DE)
(72) Erfinder: SKULTETY-BETZ, Uwe, 70771 Leinfelden-Echterdingen (DE); HAASE, Bjoern, 70182 Stuttgart (DE); RENZ, Kai, 70771 Leinfelden-Echterdingen (DE)
(86) Internationale Anmeldenummer: PCT/EP2005/053617
(87) Internationale Veröffentlichungsnummer: WO 2006/034901

(56) Entgegenhaltungen:
- EP-A- 0 163 574
- EP-A- 1 059 542
- EP-A- 1 092 989
- WO-A-96/20416
- DE-A1- 4 423 661
- DE-A1- 10 353 741
- DE-C1- 19 850 749
- GB-A- 1 187 458
- US-A- 2 680 226
- US-A- 4 513 257
- US-A- 5 952 822
- US-A1- 2002 105 331
- US-A1- 2002 112 855

## Beschreibung

Die vorliegende Erfindung betrifft einen Sensor zur Ortung metallischer Objekte nach dem Oberbegriff des Anspruchs 1 sowie ein Verfahren zur Auswertung von Messsignalen eines solches Sensors gemäß Anspruch 18.

### Stand der Technik

Sensoren beziehungsweise Detektoren zur Ortung von beispielsweise in Bauwerkstoffen verborgenen, metallischen Objekten arbeiten derzeit in der Regel mit induktiven Verfahren. Hierbei wird ausgenutzt, dass sowohl leitfähige als auch ferromagnetische Werkstoffe die Eigenschaften einer in der Umgebung angebrachten, elektromagnetischen Spule beeinflussen. Die von metallischen Gegenständen hervorgerufenen Veränderungen der induktiven Eigenschaften werden von einer Empfangsschaltung eines solchen Detektors registriert. Auf diese Weise lassen sich beispielsweise in einer Wand eingeschlossene, metallische Gegenstände mittels einer oder mehrerer über die Wand hinweg geführter Spulen prinzipiell orten.
Dabei beeinflussen magnetische und nicht magnetische metallische Objekte den induktiven Sensor in unterschiedlicher Weise. Beispielsweise kann das Einbringen eines ferromagnetischen Eisenstabs in das Magnetfeld einer Sensorspule durch eine Vergrößerung ihrer Induktivität erkannt werden. Leitfähige, nicht magnetische Materialien verursachen demgegenüber durch die in ihnen induzierten Wirbelströme eine Erhöhung der Verluste der Detektorspulen. Die Anwesenheit leitfähiger, nicht magnetischer Gegenstände im Bereich des Sensors kann somit durch eine Verringerung der Güte der Sensorspulen erkannt werden. Die Rückwirkung eines metallischen Objektes auf die Eigenschaften eines induktiven Sensors ist im allgemeinen eine Funktion des für den Sensor genutzten Frequenzspektrums. Induktive Sensoren, welche in erster Linie auf ferromagnetische Objekte, d.h. insbesondere Eisen und Stahl ansprechen sollen, arbeiten zweckmäßig bei Frequenzen im Bereich von 10 kHz und kleiner, da bei höheren Frequenzen die magnetische Suszeptibilität der meisten magnetischen Werkstoffe rasch sinkt.
Eine technische Schwierigkeit bei der Detektion metallischer Objekte besteht darin, dass die Rückwirkung der zu ortenden Gegenstände auf die Spule bzw. Spulen der Sensoranordnung betraglich sehr klein ist. Dies trifft vor allem für den Einfluss von nicht ferromagnetischen Objekten, wie beispielsweise dem technisch wichtigen Kupfer, zu.

Die auf einem induktiven Verfahren basierenden Detektoren haben in der Regel einen hohen Offset, d.h. ein hohes am Sensor abgreifbares Signal, welches bereits ohne Einfluss eines externen, d.h. zu ortenden, metallischen Gegenstands von der Empfangsschaltung des Detektors gemessen wird. Ein solcher hoher Offset macht es schwierig, sehr kleine induktive Änderungen, welche durch einen in die Nähe des Detektors gebrachten metallischen Gegenstand verursacht werden, zu detektieren.

Die Änderung ΔL der Induktivität L einer Sensorspule welche durch metallische Objekte verursacht ist, ist in der Praxis sehr gering und insbesondere sehr viel kleiner als die Induktivität L welche die selbe Spule bei Abwesenheit metallischer Objekte aufweist. Die größte technische Schwierigkeit bei der Detektion bereitet dabei nicht der geringe Absolutwert der Änderung der Sensoreigenschaften, d.h. die Induktivitätsänderung ΔL, sondern vielmehr die oft fast verschwindend geringe relative Änderung der Sensoreigenschaften, also ein extrem kleiner Quotient ΔL/L.

Besonders störend ist der Offset bei der Detektion nicht magnetischer Materialien. Der übliche Weg zur Erzielung einer hohen Messleistung ist die Verwendung von Sensorspulen besonders hoher Güte. Die geringfügige Reduktion der Spulengüte, welche durch das zu ortende Objekt hervorgerufen wird, wird dann nur in geringerem Ausmaß von den ohnehin bestehenden Spulenverlusten verdeckt. Der üblicherweise beschrittene Weg besteht darin, im Sensor Empfangsspulen mit hoher Windungszahl zu verwenden und Ferritkerne mit besonders geringen magnetischen Verlusten einzusetzen.

Die Notwendigkeit, eine sehr kleine Änderung der Sensoreigenschaften auf einem sehr großen Offset-Signal zu detektieren, setzt den Einsatz eng tolerierter und damit teuerer Bauelemente für einen solchen Detektor voraus und erfordert zudem eine sehr driftarme Analogelektronik, die die Kosten für den Sensor bzw. für ein entsprechendes Ortungsgerät deutlich erhöht.

Um dieser Offsetproblematik zu begegnen sind im Stand der Technik verschiedene Ansätze bekannt, welche alle gemeinsam zum Ziel haben, das Sensorsignal welches bei Abwesenheit metallischer Objekte vorhanden ist, zu reduzieren und somit die relativen Signaländerungen zu vergrößern.

Oft wird dabei ein mehrstufiger Ansatz gewählt, wobei z.B. in einem ersten Schritt eine Anordnung von Sensorspulen verwendet wird, welche in der Lage ist, den Signaloffset im Idealfall bereits vollständig zu beseitigen, bzw. zu kompensieren. Die in der Praxis erreichbare Kompensationsgüte hängt jedoch vielfach z.B. von Fertigungstoleranzen ab, so dass eine vollständige Beseitigung des Signaloffsets vielfach ein weiteres Verfahren, gewissermaßen zur Feinkompensation erforderlich macht.

Die gemeinsame Idee, die der im Folgenden unter dem Oberbegriff "induktiver Kompensationssensor" subsummierten Familie von Metalldetektoren zugrunde liegt, besteht darin, den Detektor aus mehr als einer Einzelspule aufzubauen und insbesondere ein Windungssystem zur Magnetfelderregung und ein Windungssystem zur Detektion zu unterscheiden. Insbesondere ist es möglich, Anordnungen zu verwenden, welche gegensinnig gewickelte Leiterschleifen derart im Raum positionieren, dass bei Abwesenheit metallischer Objekte die vom Erregermagnetfeld im Empfängersystem induzierten Spannungen verschwinden. Dies wird beispielsweise dadurch erreicht, dass von einem Erreger-Magnetfeld in gegensinnig orientierten Empfangs-Leiterschleifen Spannungen der gleichen Amplitude induziert werden, welche jedoch aufgrund der Orientierung ein entgegengesetztes Vorzeichen aufweisen und sich somit wechselseitig aufheben.

Aus der DE 101 22 741 A1 ist ein Detektor zur Ortung metallischer Gegenstände bekannt, der eine Empfangsspule und eine erste Sende- oder Erregerspule aufweist, die induktiv miteinander gekoppelt sind. Damit ein möglichst geringes Offset-Signal im Detektor entsteht, ist eine zweite Sendespule vorhanden, die ebenfalls mit der Empfangsspule induktiv gekoppelt ist. Die Empfangsspule und die beiden Sende- bzw. Erregerspulen sind konzentrisch zu einer gemeinsamen Achse angeordnet, wobei die beiden Sendespulen bezüglich ihrer Windungszahlen, Orientierung und/oder ihrer Abmessungen so dimensioniert sind, dass sich die von den beiden Sendespulen in der Empfangsspule angeregten Flüsse bei Abwesenheit metallischer Objekte gerade gegenseitig kompensieren.

Aus der US 5,729,143 ist ein Detektor bekannt, dessen Ziel es ist, den zuvor angesprochenen Offset des Messsignals möglichst weitgehend zu unterdrücken. Zu diesem Zweck weist der Detektor der US 5,729,143 eine Sendespule mit einem Sender, sowie eine Empfangsspule mit einem Empfänger auf. Die Sendespule und die Empfangsspule des Detektors sind in der Weise miteinander induktiv gekoppelt, dass sie sich teilweise gegenseitig überlappen. Die Sendespule wird vom Sender mit einem Wechselstrom gespeist. Diese stromdurchflossene Sendespule erregt durch ihre induktive Kopplung mit der Empfangsspule in dieser einen ersten Teilfluss in der Überlappungsfläche der beiden Spulen und einen zweiten Teilfluss in der restlichen Fläche der Empfangsspule. Der Abstand zwischen den Zentren von Sendespule und Empfangsspule kann nun so gewählt werden, dass sich die beiden Teilflüsse, welche ein entgegengesetztes Vorzeichen haben, gerade gegenseitig kompensieren. Ist dies der Fall, so induziert die stromdurchflossene Sendespule - wenn kein externer, metallischer Gegenstand in der Nähe der Spulenanordnung vorhanden ist - keinen Strom in der Empfangsspule, so dass der Empfänger in diesem Idealfall auch kein Offset-Signal messen würde. Erst wenn die Spulenanordnung in die Nähe eines metallischen Gegenstands gebracht wird, wird das von der Sendespule erzeugte Feld gestört, so dass nun in der Empfangsspule ein nicht verschwindender Fluss angeregt wird, der ein Messsignal in der Empfangsspule erzeugt, welches unbeeinflusst von einem Offset-Signal ist und vom Empfänger bzw. einer diesem nachgeschalteten Auswerteschaltung ausgewertet werden kann.

Dabei ist der relative Abstand der Zentren von Sendespule und Empfangsspule ein äußerst kritischer Parameter, so dass sich die idealerweise anzunehmende Abwesenheit einer induzierten Spannung in der Empfängerspule in der Praxis nur mit großem technischen Aufwand realisieren lässt. Es hat sich gezeigt, dass auf diese Weise eine hinreichende Kompensation der Flusskomponenten unter den Bedingungen einer Serienfertigung eines solchen Sensors nicht realisiert werden kann.

Aus diesem Grund schlägt die US 5,729,143 eine elektronische Schaltung vor, welche die Kompensation auf elektronischem Weg nachträglich erreicht und einen solchen Sensor somit auch praktisch nutzbar macht.

Das in der US 5,729,143 beschriebene Verfahren arbeitet monofrequent. Erregerseitig wird ein magnetisches Wechselfeld einer bestimmten Frequenz f generiert und die induzierten Spannungskomponenten werden in den Empfängerwindungen mit geeigneten, analogen und digitalen Filtern frequenzselektiv bei eben dieser Frequenz f ausgewertet. Die durch die magnetische Fehlkompensation von Empfänger- und Erregersystem in den Empfängerwindungen induzierte Spannung U(f) bei der Frequenz f verfügt über eine temperaturabhängige Amplitude und Phasenlage, die zudem zusätzlichen Exemplarstreuungen unterworfen ist. Das Verfahren der US 5,729,143 beruht nun darauf, analog zu der in den Empfängerwindungen induzierten Spannungen, eine Korrekturspannung hinzuzuaddieren, deren Amplitude und Phasenlage bei der Arbeitsfrequenz f die Fehlerspannung U(f) gerade kompensiert. Hierzu generiert ein Mikroprozessor bei der Frequenz f ein in Phase und Amplitude kontrolliertes digitales Korrektursignal. Die für die Kompensation erforderliche Amplitude und Phasenlage ist dabei von der Phasenverschiebung abhängig, welche durch die Bauelemente der Schaltungen im Erreger- und Empfängerzweig hervorgerufen werden. Das erforderliche Korrektursignal ist damit aber u. a. auch einer Temperaturdrift unterworfen. Um auch bei Veränderungen der Arbeitstemperatur die Fehlerspannung U(f) kompensieren zu können, muss der Mikroprozessor die Phasenlage und Amplitude des Korrektursignals über die Temperatur nachführen. Hierzu ist in der Regel eine Rekalibrierung des Sensors durch den Anwender erforderlich.

Eine alternative Methode zur Kompensation eines z.B. wegen Fertigungstoleranzen verbleibenden Restoffsets ist aus der EP 1092989 A1 bekannt. Bei dieser Methode wird, anstatt, dass zur Detektionsspannung, welche in den Empfängerwindungen induziert wird, eine Korrekturspannung hinzuaddiert wird, mit zusätzlichen Korrekturmagnetfeldern gearbeitet. Hierzu wird das System der Magnetfelderregung nicht nur durch die primäre Erregerspule gebildet, sondern es werden zusätzlich sogenannte Trimm-Windungen und Korrekturwindungen hinzugefügt. Der Unterschied zwischen Trimm- und Korrekturwindung ist dabei der, dass die Korrekturwindungen mit der primären Erregerspule in Reihe geschaltet sind und somit immer mit dem gleichen Strom durchflossen werden, während die sogenannten Trimm-Windungen mit einem justierbaren Bruchteil des in den Korrektur- und Erregerspulen fließenden Stroms beschickt werden können. Auf diese Weise kann erreicht werden, dass sich bei Abwesenheit metallischer Objekte in der Umgebung des Sensors in den Detektorspulen keine induzierte Spannung ergibt. Das Verfahren der EP 1092989 A1 hängt dabei wesentlich weniger von Bauelementetoleranzen und Driften in den Sende- und Empfangsschaltungen ab. Darüber hinaus ist die Messung nicht auf eine ausgewählte Arbeitsfrequenz begrenzt, da die Kompensation weitgehend unabhängig von der verwendeten Frequenz ist. Der Aufbau eines Sensors gemäß der EP 1092989 A1 wird demgegenüber jedoch wesentlich komplexer. Während der Sensor der US 5,729,143 mit nur je einer Spule für den Sende- und Empfangskreis auskommt, benötigt der Aufbau der EP 1022989 A1 im Sende- bzw. Erregerpfad zehn Spulen sowie vier Spulen für den Empfangspfad.

Im Vergleich zu Sensoren, welche kein unabhängiges Erreger- und Empfängersystem unterscheiden, erzeugen metallische Objekte in Kompensationssensoren zunächst Signaländerungen wesentlich kleinerer Amplitude. Nicht nur die vom ursprünglichen Erregermagnetfeld induzierten Spannungen heben sich im Empfangszweig weg, sondern auch die schwachen vom zu detektierenden Objekt verursachten Magnetfeldänderungen sind im Allgemeinen in gewissem Ausmaß einer Kompensation unterworfen.
Weiterhin sind in Kompensationssensoren dem Einsatz magnetischer Kerne enge Grenzen gesetzt. Die Qualität der Kompensation hängt hier empfindlich von der magnetischen Suszeptibilität des eingesetzten Ferrits ab, die häufig nicht ausreichend eng toleriert werden kann. In der Praxis kommen in Kompensationssensoren daher in der Regel Luftspulen zum Einsatz, wobei in Kauf genommen werden muss, dass die Spulengüte drastisch sinkt und insbesondere die Detektion von nicht magnetischen Materialien erschwert wird.
Ein übliches Vorgehen zur Umgehung des Problems des geringen Signals und der geringen Güte von Luftspulen bei Kompensationssensoren besteht darin, wie z.B. in der EP1092989 A1 im Detail ausgeführt, die Windungszahl im Empfangsspulensystem so hoch wie möglich zu wählen.
Ferner sind aus GB 1 187 458 A, DE 44 23 661 A1 und DE 198 50 749 C1 Sensoren zur Ortung metallischer Objekte mit einer Sendespule und einem Empfangs-Leiterschleifensystem bekannt, welche induktiv miteinander gekoppelt sind, wobei das Empfangs-Leiterschleifensystem durch Leiterstrukturen auf einer Leiterplatte gebildet ist.

### Aufgabe der Erfindung

Der Erfindung liegt die Aufgabe zugrunde, ausgehend von den Detektoren bzw. Sensoren des Stands der Technik, einen Kompensationssensor der eingangs genannten Art anzugeben, dessen Eigenschaften und Messergebnisse sich mit der Umgebungstemperatur möglichst nur geringfügig ändern, so dass auch ohne regelmäßige Kalibrierungsprozesse gute Messergebnisse mit einem solchen Sensor möglich sind.
Darüber hinaus ist es Aufgabe der Erfindung, einen derartigen Sensor insbesondere kostengünstig und mit möglichst geringen Anforderungen an Fertigungstoleranzen und kleinem Montageaufwand zu realisieren.
Die der Erfindung zugrundeliegende Aufgabe wird gelöst durch einen Sensor zur Ortung metallischer Objekte mit den Merkmalen des Anspruchs 1 und ein Verfahren zur Auswertung des Messsignals eines solchen Sensors gemäß Anspruch 18.

### Vorteile der Erfindung

Der erfindungsgemäße Sensor zur Ortung metallischer Objekte weist eine Sende- oder Erregerspule und Empfangsleiterstrukturen auf, die induktiv miteinander gekoppelt sind. Erfindungsgemäß ist zumindest der Empfangsleiterstrukturen durch ein System von Leiterbahnen auf einer Leiterplatte realisiert.

In vorteilhafter Weise ist mindestens ein Empfangsleiterschleifensystem im erfindungsgemäßen Sensor daher durch eine Kupferstruktur einer Leiterplatte, d.h. einer gedruckten Schaltung ersetzt. Dies kann beispielsweise in Form eines Print-Layouts erzeugt werden. Bei einer solchen Ausgestaltung von Leiterschleifen als Kupferstrukturen ergeben sich zum einen keine weiteren wesentlichen Kosten oder ein erhöhter Zeitaufwand für die Fertigung und Montage des Empfangswindungs-Systems. Die erfindungsgemäße Ausführung des Empfangsleiterschleifensystem als Leiterbahnstruktur auf einer Leiterplatte hat neben den nahezu verschwindenden Kosten zudem den Vorteil, dass die Dimensionstreue der Leiterschleifen sehr hoch ausgeführt sein kann. Es bereitet technisch keine großen Probleme, Kupferstrukturen auf Leiterplatten mit einer Genauigkeit von 25 Mikrometern zu fertigen.

Die Verwendung von Leiterbahnstrukturen als Empfangsleiterstrukturen führt dazu, dass die Windungszahl im Empfangssystem des Sensors deutlich reduziert sein muss. Dies wiederum führt zu einer sehr geringen Induktivität des Empfangssystems. Die Erkenntnis, das trotz des extrem geringen Induktivitätsbelags des Empfangssystems ein hochwertiger induktiver Sensor aufgebaut werden kann, welcher im Vergleich zu üblichen Kompensationssensoren potentiell sogar noch wesentlich temperaturstabiler und fertigungsfreundlicher ist, sind Gegenstand der Erfindung, ebenso wie die zur Umsetzung erforderlichen Mess- und Auswerteverfahren.

Vorteilhafte Weiterbildungen und Ausführungsformen des erfindungsgemäßen Detektors ergeben sich mit den Merkmalen der abhängigen Ansprüche.

Insbesondere für die Ortung nicht magnetischer Materialien ist die Verwendung höherer Frequenzen vorteilhaft, da bei diesen die Eindringtiefe des magnetischen Feldes in das zu ortende Objekt sinkt und somit die im Objekt induzierten Wirbelströme bedeutsamer werden. Da die Eindringtiefe in Kupfer bei einer Arbeitsfrequenz von 100 kHz bereits in der Größenordnung von rund 0.2 mm liegt, ist in der Praxis zur Erhöhung der Detektionsgüte eine Erhöhung der Arbeitsfrequenz weit über 200 kHz hinaus jedoch im allgemeinen nicht zielführend. Zumindest beim Einsatz eines induktiven Sensors zum Auffinden von Metall in Bauwerkstoffen ist diese Länge bereits wesentlich kleiner als die Abmessung relevanter Objekte, wie Stromleitungen, Wasserleitungen oder Stahlarmierungen.

Sensoren, welche sowohl auf leitfähige als auch auf ferromagnetische Objekte ansprechen sollen, müssen bezüglich der Frequenzwahl einen Kompromiss eingehen und arbeiten daher zweckmäßig in einem Frequenzbereich zwischen 1 kHz und 10 kHz. Besonders geeignet ist eine Frequenz von 4-6 kHz, da in diesem Frequenzfenster eisenhaltige Objekte und leitfähige Gegenstände vergleichbarer Größe, Messsignale näherungsweise gleicher Amplitude generieren.

Für die Verwendung einer Messfrequenz zwischen 1 kHz und 100kHz spricht auch die Tatsache, dass Auswerteschaltungen und elektronische Bauelemente hier besonders preisgünstig und mit geringem Aufwand aufgebaut werden können.

Zur genauen Einstellung der Kompensation der im Empfangspfad induzierten Spannungen in einem Kompensationssensor ist es erforderlich, zu berücksichtigen, dass die "Detektorspulen" nicht nur induktiv wirken, sondern ebenfalls einen nicht verschwindenden kapazitiven Belag aufweisen. Detektorspulen für Ortungsgeräte werden üblicherweise mit Hilfe von Kupferlackdraht gefertigt. Der für diese Spulen typischerweise verwendete Isolationslack besitzt nur eine geringe Dicke in der Größenordnung von einigen wenigen Mikrometern. Zwei neben einander liegende Wicklungen wirken somit nicht nur als Induktivität, sondern in einem gewissen Maße auch als Kondensator, mit dem Isolationslack als Dieelektrikum. Durch die geringe Isolationsdicke bei Verwendung von Lackdraht kann die parasitäre Kapazität leicht nicht zu vernachlässigende Werte annehmen. Dies ist insbesondere bei mehrlagig gewickelten Spulen der Fall. Da zur Realisierung optimaler Kompensationsgeometrien die Bestimmung der Induktivität bis in die Größenordnung von einem ppm wichtig ist, kann dieser kapazitive Einfluss auch bei Verwendung von Frequenzen von lediglich einigen kHz nicht mehr vernachlässigt werden. Hierbei gilt zu beachten, dass die sich über die parasitären Kondensatoren schließenden Ströme innerhalb der anderen Windungen der Spule hochtransformiert werden und somit in Summe zu einer bedeutenden Störpotential führen können. Die parasitäre Kapazität ist dabei zudem einer bedeutenden Temperaturdrift ausgesetzt, da die Dielektrizitätskonstante des Isolationslacks thermisch nicht stabil ist. Dies gilt insbesondere bei Verwendung sogenannten Backlacks.

In vorteilhafter Weise sind die Leiterschleifen des erfindungsgemäßen Empfangssystems automatisch planar ausgebildet, d.h. im übertragenen Sinn einlagig "aufgewickelt". Auf diese Weise ist es möglich, den Kapazitätsbelag auf einfache Weise zu reduzieren. Die planare, einlagige Geometrie ermöglicht es, den Abstand von Schleife zu Schleife groß zu halten und damit den parasitären Kapazitätsbelag zu reduzieren. Zudem ist so sichergestellt, dass der verbleibende Kapazitätsbelag thermisch fast invariant ist, so dass eine Temperaturdrift der parasitären Kapazitäten nicht mehr so relevant ist.

Der Leiterplatte, auf der die Leiterbahnstrukturen des Empfangsleiterschleifensystems ausgebildet sind, kommt eine besondere Bedeutung im erfindungsgemäßen Sensor zu. Diese Leiterplatte dient nicht nur als Trägermaterial für die notwendigen elektronischen Schaltungen des Sensors, sondern ist als Funktionsteil integraler Bestandteil des Sensors. Dabei sind diverse Bauelemente des Sensors direkt als Leiterbahnstruktur auf der Leiterplatte ausgebildet, was dazu führt, dass eine Vielzahl von einzelnen Bauelementen überflüssig wird.

Aufgrund der geringen Anzahl von Leiterschleifen ist beim erfindungsgemäßen Sensor im Allgemeinen neben der induktiven Verkopplung von Erreger- und Empfängersystem auch die parasitäre kapazitive Kopplung nicht mehr vernachlässigbar. Um diese parasitären Kopplungen in hohem Maße unterdrücken zu können, werden in vorteilhafter Weise auf der Leiterplatte zwischen der gewickelten Erregerspule und den Empfängerstrukturen zusätzlich Abschirm-Leiterstrukturen angeordnet bzw. direkt als Leiterbahnstrukturen ausgebildet. Diese Strukturen, die auf Massepotential gelegt werden können, verursachen keinerlei nennenswerte Mehrkosten bei der Herstellung des Sensors. Insbesondere können bei der erfindungsgemäßen planaren Geometrie der Empfangsleiterschleifen auch flächige Abschirmstrukturen gute Ergebnisse liefern.

Beim Aufbringen der Abschirmleitungen bzw.- -Strukturen ist allerdings darauf zu achten, dass sich innerhalb der Abschirmgeometrie keine Stromschleifen schließen können. In vorteilhafter Weise werden die Abschirmstrukturen daher als Mäander- oder Kamm-Strukturen aus möglichst dünnen Einzelleitern ausgebildet.
Die als Sende- oder Erregerspule arbeitende Spule befindet sich in einer zur Leiterplatte in der Höhe versetzten, d.h. in einer z-Richtung verschobenen, parallelen zweiten Ebene. Dies ermöglicht in vorteilhafter Weise, dass auch unterhalb der Sendespule zusätzliche Windungen angeordnet werden können, welche es gestatten, die Anforderungen an die Positionier- und Abmessungstoleranzen der Erregerspule erheblich zu reduzieren.

Eine Fehlpositionierung der Erregerspule relativ zur vorgesehenen Position wirkt sich auf die unterschiedlich orientierten Einzel-Leiterschleifen in um so geringerem Maß aus, je größer der Abstand zur betreffenden Empfangswindung ist. D.h. bei einer Fehlpositionierung der Erregerspule ändert sich die induzierte Spannung in einer näher liegenden Empfangs-Leiterschleife ggf. stärker als in einer gegensinnig orientierten und weiter entfernt liegenden Leiterschleife. Im Ergebnis kann daher eine gute Kompensation der induzierten Spannungsamplituden nur bei einer hohen Positionstreue gewährleistet werden.

Zusätzlich zu den Windungen bzw. Leiterschleifen des Empfangssystems, welche sinnvollerweise in großem Abstand zur Sendespule angeordnet sind, werden unterhalb der Erregerspule Kompensationswindungen angeordnet, welche im Idealfall keinen Einfluss auf das vom zu detektierenden Objekt generierte Messsignal haben sollen.

Dabei sind Anzahl und Position der jeweiligen Kompensationswindungen so zu dimensionieren, dass die Abhängigkeit der induzierten Spannung im Empfangsleiterschleifensystem von einer Höhenfehlpositionierung der Erregerspule, d.h. einer Fehljustierung in z-Richtung, möglichst genau kompensiert wird. Eine geringfügige Fehlpositionierung der Erreger- oder Sendespule in z-Richtung wirkt sich auf die in den Empfangswicklungen in der Summe induzierte Spannung somit nicht mehr bzw. nicht mehr so stark aus.

In vorteilhafter Weise sind auch die Kompensationswindungen als Kupferstrukturen auf einer Leiterplatte realisiert. Idealerweise werden die Kompensationswindungen und die Windungen der Empfangsspulen auf der selben Leiterplatte als Leiterbahnstruktur ausgebildet.

Bei einer solchen Detektorgeometrie ergibt sich eine deutlich reduzierte Toleranzempfindlichkeit bezüglich der Positionierung der Erregerspule in ihrer Höhe (z-Richtung) über der Ebene der Empfangsspulen.

In einer vorteilhaften Weiterbildung des erfindungsgemäßen Sensors sind die Kompensationswindungen der Empfangsleiterschleifensysteme auf zwei gegenüberliegende Seitenflächen einer Leiterplatte ausgebildet. Hierbei werden zwei, im und entgegen den Uhrzeigersinn gewickelte Kompensationsschleifen bei möglichst gleicher Geometrie in unterschiedlicher Höhe, z.B. auf zwei Seiten der Leiterplatte und vorteilhaft als Leiterbahnstruktur aufgebracht.

Dadurch, dass die innen im Sensor liegenden Kompensationswindungspaare auf der Ober- und Unterseite der Leiterplatte nahezu identisch ausgeformt sind, wird die Richtcharakteristik des Sensors bei großen Abständen zu den metallischen Objekten nicht verfälscht. Auf diese Weise ist es möglich, die Kompensationswindungen unterhalb der Erregerspule anzuordnen, ohne dass die Richtcharakteristik des induktiven Sensors negativ beeinflusst wird.

In vorteilhafter Weise ist die Sendespule des erfindungsgemäßen Sensors auf einem Wickelkörper aufgebracht, der bei der Montage anschließend auf der Leiterplatte befestigt, beispielsweise aufgelötet oder eingeclipst wird. Die Wicklungen der Erreger- oder Sendespule befinden sich somit in einer bestimmten, definierten Höhe oberhalb der Leiterplatte und somit oberhalb der Ebene der Empfangsleiterstrukturen. Der die Wicklungen der Sendespule tragende Wickelkörper dient somit in vorteilhafter Weise auch als mechanischer Abstandshalter der Sendespule bzw. ihrer Wicklungen relativ zu den Leiterschleifen des Empfangssystems und garantiert somit einen definierten Abstand von Sende- und Empfangswindungen.

In besonders vorteilhafter Weise wird die Erregerspule elektrisch über in ein Spritzgussteil eingelassene Kontaktstifte kontaktiert, welche in dafür vorgesehene Bohrungen auf der Leiterplatte verlötet werden. Um eine stabile, auch mechanische Kontaktierung zu ermöglichen, ist es dabei hilfreich, mehr als die zwei elektrisch benötigten Kontaktstifte zu verwenden und beispielsweise ein oder zwei blinde, d. h. elektrisch nicht kontaktierte Pins zusätzlich zu setzen. Auf diese Weise kann die Erregerspule durch einen Lötprozess auch mechanisch präzise fixiert werden.

Ein derartiger Detektor zur Ortung metallischer Objekte mit der erfindungsgemäßen Sensorgeometrie benötigt somit in vorteilhafter Weise nur eine einzelne gewöhnliche Spule und macht weitere gewickelte Sensorspulen ebenso überflüssig, wie die sonst erforderliche hochgenaue Positionierung der Einzelspulen. Darüber hinaus weist der erfindungsgemäße Sensor zudem eine gute Richtwirkung der Detektion auf und zeigt nur ein geringfügiges Driftverhalten bei Temperaturänderungen.

Die beschriebenen Maßnahmen gestatten es, den trotz Fertigungstoleranzen und thermischer Drift verbleibenden Signaloffset erheblich zu reduzieren. Um die Detektion sehr kleiner metallischer Objekte zu ermöglichen, kann es jedoch wünschenswert sein, den Offset noch weiter zu verringern.

Die erfindungsgemäße Lösung besteht darin, im Gegensatz zu den bekannten Verfahren der elektrischen Feinkompensation oder Erregerfeldmodifikation, die Empfangsgeometrie zu modifizieren. Hierzu können mit Hilfe von Schaltmitteln Leiterschleifen oder Bruchteile davon zum Empfangssystem dazu- oder weggeschaltet werden. Bei geeigneter Dimensionierung dieser Abgleichschleifen kann es erreicht werden, dass die in diesen Leiterzügen induzierte Spannung die verbleibende Offsetspannung gerade kompensiert.

Eine besonders vorteilhafte technische Lösung stellt es dar, wenn die Leiterschleifen zur Feinkompensation als Leiterzüge auf einer Leiterbahn ausgebildet sind, da so ebenfalls die hohe fertigungsbedingte Dimensionstreue von wenigen 10 µm und die Möglichkeit, die Geometrie dieser Abgleichleiterschleifen fast beliebig zu wählen, zum Tragen kommt.

Die Verwendung von Leiterzügen auf der Leiterplatte zum Ersatz der Spulen des Empfangssystems und/oder zur Realisierung von Shuntwiderständen und/oder Abgleichwindungen hat eine Reihe Konsequenzen für die anschließende Signalverarbeitung, die zu einer erfindungsgemäßen Auswerteelektronik bzw. einem entsprechenden Auswerteverfahren geführt hat

Auf der einen Seite sind durch die in den vorangegangen Abschnitten beschriebenen Maßnahmen Offsetunterdrückungen in einem so hohen Maß möglich geworden, dass für den erfindungsgemäßen Sensor nunmehr nur noch Drifteffekte wichtig werden, die bei gewöhnlichen Detektoren nicht sichtbar waren, da sie zumeist von der dort verbliebenen Drift des Offsets vollständig überdeckt wurden. Insbesondere macht sich nunmehr bei dem erfindungsgemäßen Sensor die Änderung des ohmschen Widerstands der Erregerspule mit der Temperatur bemerkbar. Die Erfindung beschreibt eine vorteilhafte Lösung, bei der mit Hilfe eines Shuntwiderstandes die Veränderung des Stroms in der Erregerspule vermessen wird und eine Kompensation dieser Drifteffekte gelingt. Vorteilhafterweise wird dabei an zwei Seiten eines Shuntwiderstandes, durch welchen der Erregerstrom fließt, eine Messspannung abgegriffen und ausgewertet. Bei Verwendung von zwei Abgriffpunkten lässt sich in vorteilhafter Weise eine Variation des Massepotentials auf der Leiterplatte kompensieren. In einer vorteilhaften Ausführung besteht das widerstandsbestimmende Material des Shuntwiderstands selbst aus Kupfer.

Bei Kenntnis von Strom und Phasenlage des Stroms im Erregerzweig ist es möglich, eine beispielsweise auftretende Verringerung der Messamplitude, welche z.B. dadurch hervorgerufen wird, dass der Strom im Erregersignal durch eine Erhöhung des Kupferwiderstands der Erregerspule mit der Temperatur sinkt, rechnerisch ebenso zu kompensieren, wie eine ggf. resultierende Phasenverschiebung.

In vorteilhafter Weise kann ein solcher Shuntwiderstand ebenfalls durch einen Leiterzug auf der Platine gebildet werden. Aufgrund des hohen Verstärkungsfaktors der Auswerteschaltung eines solchen Sensors reichen sehr geringe Spannungsamplituden am Shuntwiderstand aus, so dass auch dieser vorteilhaft durch eine kurze Mäanderstruktur aus Kupferleiterzügen auf der Platine gebildet werden kann und auf diese Weise ein zusätzliches separates Bauelement vermieden wird. In der Praxis reichen dazu rund 1-2cm an Leiterstrukturen als Shuntwiderstand aus.

In einer besonders vorteilhaften Ausführungsform des erfindungsgemäßen Sensors wird zur Vermessung des Stroms im Shuntwiderstand der gleiche Messverstärker eingesetzt, welcher auch zur Auswertung der im Empfangsleiterschleifensystem induzierten Spannung eingesetzt wird. Dies kann durch Einsatz geeigneter Schaltmittel am Eingang des Messverstärkers realisiert werden. Der Vorteil besteht darin, dass auf diese Art und Weise Langzeit- und Temperaturdrifteffekte innerhalb des Messverstärker-Schaltkreises sich auf die Vermessung der Shuntsignale in identischer Weise auswirken wie auf die Spulensignale. Weiterhin werden Kosten für den Aufbau eines separaten Messverstärkers für die Shunt-Spannung vorteilhaft vermieden, welche selbst bei Berücksichtung der Kosten für die erforderlichen Schaltmittel zu einer erheblichen Kostenreduktion führen.

Die Vorteile der hohen Dimensionstreue im Empfangssystem und die damit erzielbare Offsetkompensation wird beim erfindungsgemäßen Sensor vor allem dadurch erkauft, dass die Anzahl der Detektorwindungen extrem limitiert ist. Die dadurch hervorgerufenen extrem geringen Signalpegel mit Spannungen in der Größenordnungen von nur wenigen 10 nV verlangen nach spezifischen schaltungstechnischen Lösungen und einer geeigneten Signalprozessierung zur Reduzierung der Rauschbandbreite und zur Unterdrückung parasitärer Störsignale bei der Auswertung der Messsignale.

Bei den geringen Signalpegeln und den somit erforderlichen hohen Verstärkungsfaktoren ist einerseits auf eine besonders rauscharme Auslegung der Messverstärker zu achten, welche mit bipolaren Eingangsstufen des Messverstärkers und sehr niederohmigen Rückkopplungs-Widerständen besonders vorteilhaft realisiert werden kann. Andererseits führt die Kombination von extrem hohem Verstärkungsfaktor und geringem Signalpegel dazu, dass z.B. ein Übersprechen von Störsignalen in der Versorgung des Messverstärkers auf dessen Eingang bedeutsam werden kann. Die Erfindung schlägt vor, mit Hilfe eines geeigneten Schaltmittels den Eingang des Messverstärkers direkt auf Massepotential zu legen, um die Amplitude dieser Störsignale vermessen zu können und diese in einer anschließenden digitalen Signalprozessierung von den Messsignalen zu subtrahieren.

Zur Auswertung des erfindungsgemäßen Sensors wird vorgeschlagen, dass eine schmalbandige, digitale Filterung der Messsignale zur Reduzierung der Rauschbandbreite durchgeführt wird. Dabei wird in vorteilhafter Weise eine digitale Generierung des Erregersignals und eine phasensynchrone Analog-Digital-Konvertierung des Ausgangssignals eines Messverstärkers des Sensors durchgeführt. Vorteilhaft entspricht die Frequenz der Analog-Digital-Konvertierung mindestens dem vierfachen der Oszillationsfrequenz der Magnetfelder.

Die Erfindung ermöglicht es, einen kostengünstigen Sensor zu realisieren, welcher möglichst viele der kostenintensiven Bauteile und Geräteelemente dadurch überflüssig macht, dass die Leiterplatte des Sensors nicht nur als Trägermaterial für die elektronischen Schaltungen eingesetzt wird, sondern als Funktionsteil integraler Bestandteil des Sensors ist, in dem diverse Bauteile direkt als Leiterbahnstrukturen des Funktionsteils ausgebildet sind..

Dies wird beispielsweise erreicht durch den Ersatz der bislang typischerweise verwendeten, gewickelten Empfangsspule durch erfindungsgemäße Leiterzüge auf der Leiterplatte, sowie das Vorsehen von geeigneten Leiterzügen auf der Leiterplatte zur Abschirmung von Erreger- und Detektorspule zur Unterdrückung einer kapazitiven Verkopplung der Windungen. Darüber hinaus kann beispielsweise auch ein Shuntwiderstand, welcher es ermöglicht, den Strom im Erregerzweig des Sensors zu vermessen und so die Temperaturdrift des Stroms in der Erregerspule zu bestimmen, direkt durch eine Leiterbahn dieser Leiterplatte realisiert werden.

In vorteilhafter Weise kann durch den Einsatz geeigneter Schaltmittel die Auswertung der Messsignale und der Shuntsignale in ein und demselben Verstärker erfolgen, welcher idealerweise zusätzlich gestattet, einen ggf. vorhandenen Hintergrund aus parasitären Störsignalen separat zu vermessen. Auf diese Art und Weise erfolgen beispielsweise Drifteffekte bei der Verstärkung gleichsinnig und können kompensiert werden können.

Dadurch ist ein induktiver Kompensationssensor realisierbar geworden, der
in einem ersten Schritt eine vorteilhafte Lösung zur Grobkompensation des Offsetsignals eines induktiven Sensors aufweist, durch die Vermeidung von zusätzlichen Spulen, sowie die Berücksichtigung von Fertigungstoleranzen,
in einem zweiten Schritt eine vorteilhafte Lösung zum temperaturinvarianten Feinabgleich dieses Sensors ermöglicht, sowie
durch seine Auswerteschaltung vorteilhafte Lösungen und Verfahren ermöglicht, um durch eine analoge und digitale Signalverarbeitung für einen derartigen Sensor spezifische technische Probleme, wie beispielsweise extrem geringe Signalamplituden zu lösen.

Der erfindungsgemäße Sensor mit seinen zuvor dargelegten Vorteilen ermöglicht somit ein zuverlässiges und preiswertes Messgerät, insbesondere einen Detektor zur Ortung metallischer Gegenstände, der ohne regelmäßigen Kalibrierungsprozess unabhängig von der Temperatur gute Messergebnisse liefert. Ein solches Messgerät kann beispielsweise als ein handgehaltenes Ortungsgerät ausgebildet sein.

Darüber hinaus ist es in vorteilhafter Weise möglich, den erfindungsgemäßen Sensor in oder an einer Werkzeugmaschine zu integrieren, um dem Anwender ein gefahrloses und sicheres Arbeiten mit einer solchen Maschine zu ermöglichen. So kann der Sensor beispielsweise in einem Bohr- oder Meißelwerkzeug integriert werden oder als ein mit einem solchen Werkzeug verbindbares Modul ausgebildet sein. Als ein möglicher Einbauort für den erfindungsgemäßen Sensor bietet sich in vorteilhafter Weise beispielsweise eine Absaugvorrichtung für Staub an, die mit der Werkzeugmaschine verbunden ist, oder mit dieser verbindbar ist, und funktionsbedingt in der Nähe einer zu bearbeitenden Wand zum Einsatz kommt.

### Zeichnung

In der Zeichnung sind Ausführungsbeispiele des erfindungsgemäßen Sensors dargestellt, die in der nachfolgenden Beschreibung näher erläutert werden sollen. Die Figuren der Zeichnung, deren Beschreibung sowie die Ansprüche enthalten zahlreiche Merkmale in Kombination. Ein Fachmann wird diese Merkmale auch einzeln betrachten und zu weiteren, sinnvollen Kombinationen zusammenfassen, die somit als ebenfalls in der Beschreibung offenbart anzusehen sind.

Es zeigen:
- Fig. 1: den prinzipiellen Aufbau einer Sensorgeometrie eines Sensors zur Ortung metallischer Objekte nach dem Stand der Technik in einer schematisierten Darstellung,
- Fig. 2: ein erstes Ausführungsbeispiel einer Spulenanordnung des erfindungsgemäßen Sensors in einer vereinfachten, schematischen Darstellung,
- Fig. 3: ein zweites Ausführungsbeispiel einer Spulenanordnung des erfindungsgemäßen Sensors in einer zu Fig. 2 analogen Darstellung,
- Fig. 4: ein Layout für eine Leitergeometrie der Empfängerwindungen des erfindungsgemäßen Sensors in einer Aufsicht auf eine Leiterplattenstruktur,
- Fig. 5: eine Unteransicht der Leiterplattenstruktur der Leiterplatte gemäß Figur 4,
- Fig. 6: eine schematische Darstellung einer Auswerteschaltung zur Auswertung und Aufbereitung von Messsignalen des erfindungsgemäßen Sensors.

### Beschreibung der Ausführungsbeispiele

Zur Einführung wird im Folgenden zunächst kurz auf das aus dem Stand der Technik bekannte Prinzip zur Grobkompensation des Offsets bei Verwendung von drei konzentrischen Sensorspulen eingegangen.

Gegenstand des darauf folgenden Abschnitts ist das erfindungsgemäße Prinzip, welches dazu führt, dass die mit dem Aufbau realisierbare Grobkompensation unempfindlicher auf Fertigungs- und Montagetoleranzen reagiert. Insbesondere wird auf den Einsatz von zusätzlichen Kompensationswindungen zu diesem Zweck eingegangen, gezeigt, auf welchem Wege es vermieden werden kann, dass diese Kompensationswindungen auf die Richtcharakteristik des Sensors Einfluss nehmen.

Im Anschluss daran wird ein Layout eines Ausführungsbeispiels beschrieben, das die Realisierung des erfindungsgemäße Sensorprinzip zeigt. Anhand dieses Beispiels wird anschließend beispielhaft aufgezeigt, wie Abschirmgeometrien zur Unterdrückung von kapazitiver Verkopplung zwischen Erreger- und Empfängerpfad eingesetzt werden können und wie mit Hilfe von Schaltmitteln ein Feinabgleich des Offsets möglich ist, indem Leiterschleifen auf der Leiterplatte selektiv dazu- oder weggeschaltet werden können.

Der abschließende Abschnitt der Beschreibung befasst sich mit einem Ausführungsbeispiel der schaltungstechnischen Lösungen und dem Verfahren der Signalverarbeitung, welche insbesondere erforderlich sind, um trotz der erfindungsspezifisch extrem geringen Signalamplituden eine gute Messleistung sicherstellen zu können.

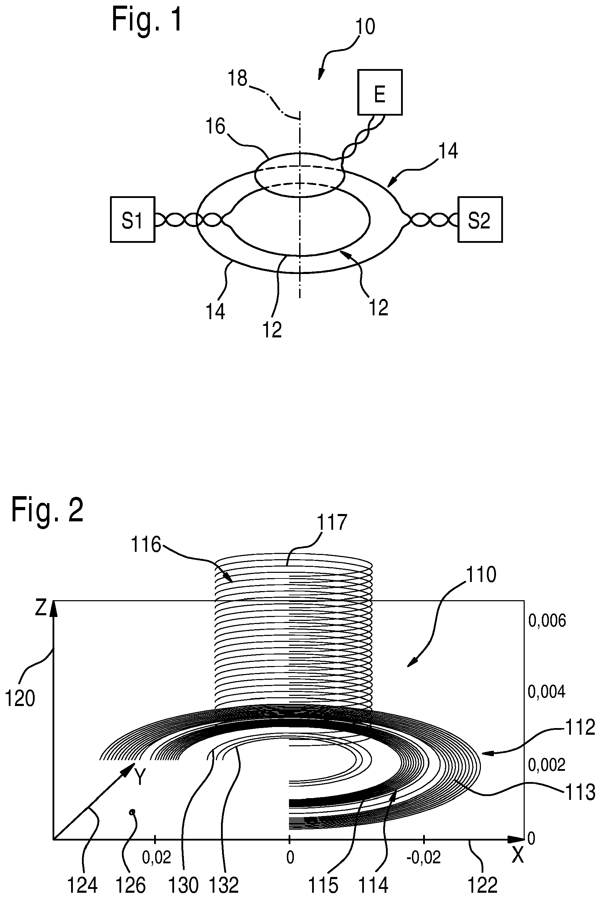

Fig. 1 zeigt zur Verdeutlichung des Basisprinzip eines Kompensationssensors den prinzipiellen Aufbau eines Sensors bzw. Detektors zur Ortung metallischer Gegenstände nach dem Stand der Technik. Die Begriffe Detektor und Sensor werden im Rahmen dieses Textes synonym verwendet. Ein solcher Detektor weist in seiner Sensorgeometrie 10 drei Spulen auf. Eine erste Sendespule 12, die an einen ersten Sender S1 angeschlossen ist, eine zweite Sendespule 14, die an einen zweiten Sender S2 angeschlossen ist und eine Empfangsspule 16, die an einem Empfänger E angeschlossen ist. Jede Spule ist hier als kreisförmige Linie dargestellt. Die Besonderheit der Anordnung dieser drei Spulen 12, 14, 16 besteht darin, dass sie alle konzentrisch zu einer gemeinsamen Achse 18 angeordnet sind. Dabei haben die einzelnen Spulen 12, 14, 16 unterschiedliche Außenabmessungen, so dass die Spule 12 in die Spule 14 koaxial zur Achse 18 einsetzbar ist.
Die beiden Sendespulen 12 und 14 werden von ihren Sendern S1 und S2 mit Wechselströmen entgegengesetzter Phase gespeist. Damit induziert die erste Sendespule 12 in der Empfangsspule 16 einen Fluss, der den von der zweiten Sendespule 14 in der Empfangsspule 16 induzierten Fluss entgegengesetzt gerichtet ist. Beide in der Empfangsspule 16 induzierten Flüsse kompensieren sich gegenseitig, so dass der Empfänger E kein Empfangssignal in der Empfangsspule 16 detektiert, falls sich kein externer, metallischer Gegenstand in der Nähe der Spulenanordnung 10 befindet. Der von den einzelnen Sendespulen 12 bzw. 14 in der Empfangsspule 16 erregte Fluss φ hängt von verschiedenen Größen ab, wie beispielsweise der Windungszahl und der Geometrie der Spulen 12 bzw. 14 und von den Amplituden der in die beiden Sendespulen 12 bzw. 14 eingespeisten Ströme sowie der gegenseitigen Phasenlage dieser Ströme.

Diese Größen sind bei den Detektoren des Standes der Technik letztendlich so zu optimieren, dass bei Abwesenheit eines metallischen Gegenstands in der Empfangsspule 16, bei stromdurchflossenen Sendespulen 12 bzw. 14 kein Fluss bzw. ein möglichst geringer Fluss φ angeregt wird. Bei der Spulenanordnung 10 gemäß Fig. 1 sind die erste Sendespule 12, die an den ersten Sender S1 angeschlossen ist und eine zweite Sendespule 14, die an einen zweiten Sender S1 angeschlossen ist, koaxial zueinander in einer gemeinsamen Ebene angeordnet. Die Empfangsspule 16 ist in einer gegenüber den beiden Sendespulen 12 und 14 versetzten Ebene angeordnet.

Fig. 2 zeigt ein erstes Ausführungsbeispiel einer Sensorgeometrie 110 für einen erfindungsgemäßen Sensor zur Ortung metallischer Objekte in einer stark vereinfachten Prinzipdarstellung. Dieser optimierte Aufbau einer Sensorgeometrie verringert die Toleranzempfmdlichkeit bezüglich der Positionierung der Erregerspule in der Höhe. Die Sensorgeometrie 110 gemäß Fig. 2 weist zwei Blöcke gegensinniger Empfangs-leiterschleifen 112 bzw. 114 auf, die in einer gemeinsamen Ebene 126 koaxial zueinander angeordnet sind. Mit einem gewissen Abstand z über dieser gemeinsamen Empfängerebene 126 befindet sich eine Senderspule 116, die ebenfalls koaxial zum Empfängersystem 112 bzw. 114 angeordnet ist.

Die Leitungssegmente der Empfangsleiterschleifen 112 bzw. 114 besitzen eine planare, einlagige Wickelgeometrie. Eine solche Ausbildung des Empfangsleiterschleifensystems 112, 114 eröffnet die Möglichkeit, den Kapazitätsbelag auf einfache Weise zu minimieren. Hierbei ist es möglich, den Abstand von Windung zu Windung groß und damit den parasitären Kapazitätsbelag klein zu halten.
In noch zu beschreibender Weise sind die Empfangsleiterschleifen im Print-Layout d.h. als Leiterbahnstrukturen, bzw. als gedruckte Leiterschleifen auf einer Leiterplatte ausgebildet.
Bei einer solchen Realisierung fallen keine Kosten für die Fertigung und Montage von Empfängerspulen an. Der Ersatz der beiden Empfängerspulen durch Leiterbahnstrukturen 112 bzw. 114 auf einer Leiterplatte hat neben den verschwindenden Kosten zudem den Vorteil, dass die Dimensionstreue der Windungen sehr hoch ist. Es bereitet technisch keinerlei Probleme, Kupferstrukturen auf Leiterplatten bis auf 25 Mikrometer genau zu fertigen.

Fig. 2 zeigt eine Spulenkonfiguration des Sensors - zur Verdeutlichung der Anordnung der Empfangswindungen - in ebenfalls stark schematischer Weise. Hierbei ist zur besseren Sichtbarkeit die Z-Achse 120 relativ zu den X- und Y-Achsen 122 bzw. 124 gedehnt. Zur Verdeutlichung dieser Darstellung befinden sich entsprechende Maßzahlen an den jeweiligen Achsen der Figur, die jedoch keine Absolutwerte, sondern lediglich die relative Größe der Skalierung der einzelnen Achsen in diesem Ausführungsbeispiel in beliebigen Einheiten vermitteln soll. Weiterhin wurde in Fig. 2 zur besseren Sichtbarkeit der Querschnitte jeweils ein Segment aus den Spulen ausgeschnitten.

In einer Ebene 126, die hier eine nicht weiter dargestellte Leiterplatte 100 symbolisieren soll, und in Figur 2 von der X-Achse 122 und der Y-Achse 124 aufgespannt wird, liegen die beiden gegensinnig orientierten Empfangsleiterschleifen 112 bzw. 114. Diese Ebene 126 kann dabei beispielsweise der Ober- oder der Unterseite der Leiterplatte 100 entsprechen. Die Windungen 115 des Empfangssystems 114 sind dabei beispielsweise im Uhrzeigersinn gewickelt, während die weiter außen liegenden Windungen 113 der Strukturen 112 entgegen dem Uhrzeigersinn orientiert sind. Die in diesen Windungen 113, 115 induzierten Spannungen haben somit entgegengesetztes Vorzeichen und kompensieren sich bei geeigneter Dimensionierung im Falle der Abwesenheit externer metallischer Objekte vollständig.

Oberhalb der Ebene 126 der Leiterplatte 100, d.h. in Z-Richtung 120 versetzt, befindet sich eine Erreger- bzw. Sendespule 116. Besonders vorteilhaft ist es, wenn die Sendespule auf einem Wickelkörper gefertigt wird, der anschließend auf die Leiterplatte 126 aufgelötet werden kann. Die Wicklungen 117 der Sendespule 116 befinden sich somit in einer bestimmten, vordefinierten Höhe z oberhalb der Leiterplattenebene 126. Wegen der erforderlichen Stabilität ist die Fertigung von Wickelkörpern mit Wandstärken unterhalb von einem Millimeter kritisch. Daher sind Abstände von einem Millimeter und mehr zwischen Leiterplatte und Sendespule 116 anzustreben.

Der in Fig. 2 gezeigte Aufbau ist bezüglich einer Fehlpositionierung der Sendespule 116 in radialer, d.h. X- bzw. Y-Richtung 122 bzw. 124 wenig kritisch, wie dies auch bereits im Stand der Technik, beispielsweise in der DE 10122741 A1 aufgezeigt worden ist. Zur zusätzlichen Kompensation von Fehlpositionierungen in Z-Richtung 120 weist die erfindungsgemäße Sensorgeometrie 110 gemäß Fig. 2 zusätzlich zu den aus dem Stand der Technik bekannten Empfangswindungen 115 bzw. 113, die im Außenbereich des Sensors angeordnet sind, direkt unter der Sendespule 116 Kompensationswindungen 130 bzw. 132 auf. Im Ausführungsbeispiel der Fig. 2 bestehen diese Kompensationswicklungen aus zwei Windungen 132 im und einer Windung 130 entgegen dem Uhrzeigersinn. Zudem kann die Kompensationswirkung durch die Anpassung der Radien der Kompensationswindungen 130 bzw. 132 optimiert werden. Anzahl und Position der Kompensationswindungen sind dabei so zu dimensionieren, dass die Abhängigkeit der induzierten Spannung im Empfangsleiterschleifen 114 mit Empfangswindungen 115 und Kompensationswindungen 130 bzw. im Empfangsleiterschleifen 112 mit Empfangswindungen 113 und Kompensationswindungen 132 bezüglich einer Fehlpositionierung der Sendespule 116 in z-Richtung 120 kompensiert wird. Die Kompensationswindungen 130 bzw. 132 sind unterhalb der Sendespule 116 in der gleichen Ebene 126 angeordnet, wie das Empfangs-Leiterschleifensystem 112 und 114 und verlaufen zu diesen koaxial. Die Radien der Kompensationswindungen 130 bzw. 132 sind daher unterschiedlich jedoch kleiner gewählt als die Radien der Empfängerwindungen 112 und 114, so dass die Kompensationswindungen 130 bzw. 123 unter der Sendespule 116 liegen. Die Kompensationswindungen können dadurch ebenfalls als Printstrukturen auf der gemeinsamen Leiterplatte realisiert werden. Die Radien für die Kompensationsschleifen 130 bzw. 132 können jedoch auch größer oder kleiner sein, als der Radius der Windungen 117 der Sendespule 116.

Diese Kompensation geschieht dadurch, dass der aufgrund der größeren Entfernung geringere Einfluss der Fehlpositionierung der Sendespule 116 auf das Windungssystem 113 der Empfangsleiterschleifen 112 dadurch ausgeglichen wird, dass in sehr geringem Abstand zur Sendespule 116 ebenfalls Empfängerkompensationswindungen 132 der Empfangs-Leiterschleifen 112 gesetzt sind. Diese Kompensationswindungen 132 werden von einer Verschiebung der Sendespule 116 um so mehr beeinflusst. Eine geringfügige Fehlpositionierung der Sendespule 116 wirkt sich auf die in den Empfangswicklungen in der Summe, d.h. einschließlich ihrer Kompensationswindungen 130 und 132, induzierten Spannung somit nicht aus. Dies gelingt idealer Weise selbstverständlich nur für ein enges Fenster im Bereich der eigentlich vorgesehenen Z-Position der Sendespule 116. Die Forderung an die Fertigungstoleranz der Wandstärke eines Wickelkörpers für die Sendespule 116 kann so beispielsweise auf einfach realisierbare +/- 0,1 mm verringert werden.

Die so erreichte höhere Fertigungsfreundlichkeit bei einer Sensorgeometrie 110 gemäß dem Ausführungsbeispiel der Fig. 2 wird jedoch dadurch erkauft, dass durch das Hinzufügen der Kompensationswindungen 130 bzw. 132 unterhalb der Erregerspule 116 die RichtCharakteristik des induktiven Sensors negativ beeinflusst wird.

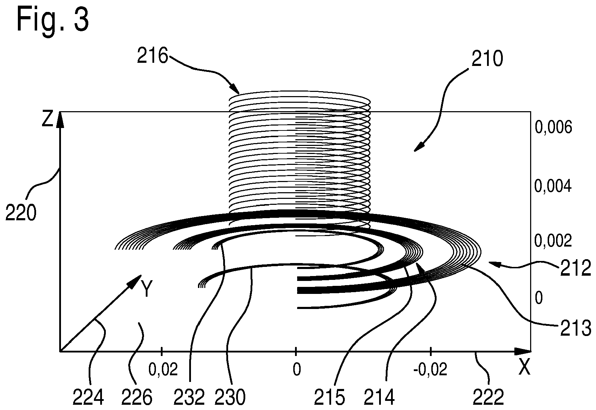

Fig. 3 zeigt in einem alternativen Ausführungsbeispiel einer Sensorgeometrie 210 für den erfindungsgemäße Sensor zur Ortung metallischer Objekte einen Kompensationsaufbau, welcher das Problem der verfälschten Richtcharakteristik deutlich entschärft. Bei diesem Ausführungsbeispiel werden die im bzw. entgegen dem Uhrzeigersinn gewickelten Kompensationswindungen 230 bzw. 233 auf zwei unterschiedlichen Seiten beispielsweise einer Leiterplatte 200, die durch die Ebene 226 angedeutet sein soll, aufgebracht. Eine solche Leiterplatte muss dabei also mindestens zweilagig ausgeführt werden. Darüber hinaus gehende mehrlagige Leiterplatten sind aber ebenso möglich. Dadurch, dass die innen liegenden Kompensationswindungspaare dann mit nahezu gleichem Radius ausgebildet werden können, wird die Richtcharakteristik des Sensors bei großen Abständen zu metallischen Objekten nicht mehr verfälscht. Da der Radius der Kompensationswindungen 230 bzw. 232 nun nahezu gleich ist, wird deren jeweilige Windungszahl genutzt, um eine optimierte Anpassung der Positionierungstoleranz für die Sendespule 216 zu ermöglichen.

Die verbesserte Richtcharakteristik des erfindungsgemäßen Sensors gemäß Figur 3 kann man sich anschaulich durch das folgende qualitative Argument erklären. Würde man die Empfängerwindungen 215 und 230 bzw. 213 und 232 bestromen, so wird durch die innen liegenden und auf die Ober- und Unterseite der Leiterplatte 200 verteilten Kompensationswindungen 230 bzw. 232 ein Magnetfeld generiert, welches in guter Näherung einem magnetischen Quadropol entspricht. Das Feld verschwindet in Abständen, die groß zum Abstand der beiden Kompensationswicklungssysteme 230 bzw. 232 auf Ober- und Unterseite der Leiterplatte 200 sind, somit mit zunehmender Distanz sehr schnell. Bereits in einem Abstand von ungefähr einem Zentimeter zur Leiterplatte tragen die innen liegenden Kompensationswindungen 230 und 232 nicht mehr merklich zum Gesamtmagnetfeld bei. Diese für die Nutzung der Kompensationswindungen zur Magnetfelderzeugung gültigen Überlegungen lassen sich auch auf die sich ergebenden Empfangscharakteristiken übertragen.

Während die Kompensationswindungen 230 bzw. 232 gemäß Fig. 3 nur zu einer geringfügigen Deformation der Empfangscharakteristik führen, ist ihr Einfluss auf die in den Empfangswindungen 215 bzw. 213 induzierte Spannung nicht zu vernachlässigen.

Die Sendespule 216 befindet sich in einem Abstand von ca. 1 mm oberhalb der Leiterplatte, wobei dieser Abstand in etwa gleich groß ist, wie die Dicke der Leiterplatte selbst.

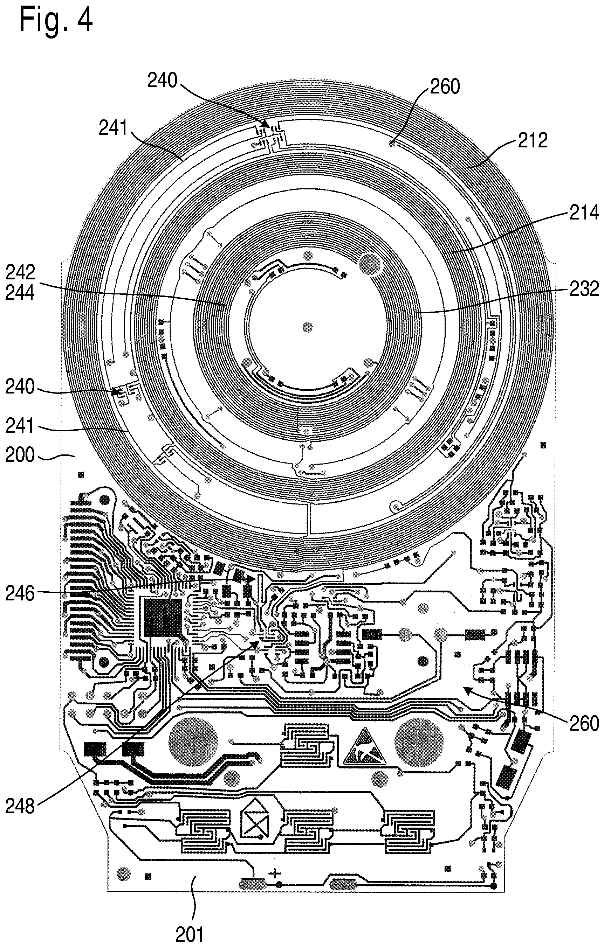

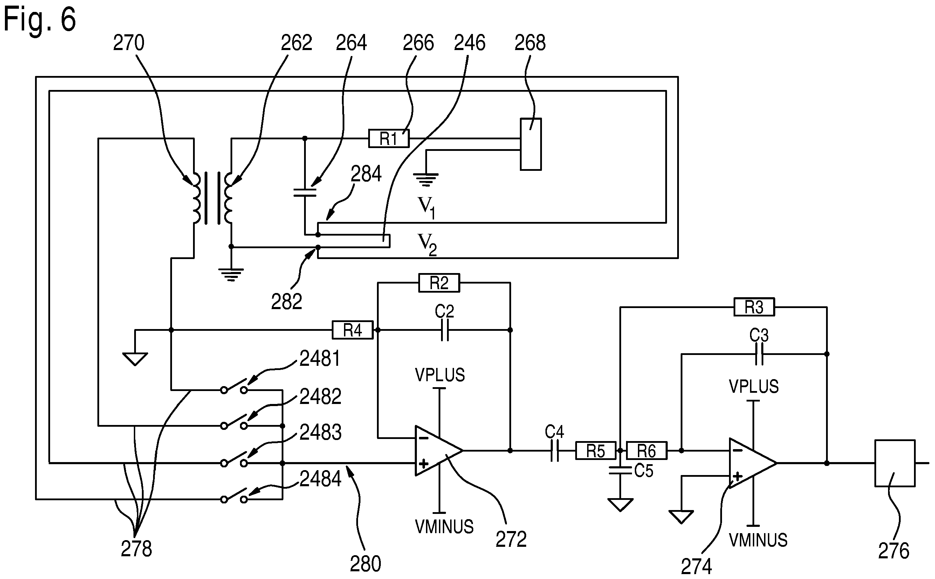

Figur 4 zeigt eine mögliche Realisierung des zuvor gezeigten Empfangsleiterschleifensystems und Kompensationswindungen als Printstrukturen auf einer Leiterplatte 100, bzw. 200 in einer Aufsicht auf die Oberseite 201 der Leiterplatte 200. Im folgenden wird lediglich das Layout der Leiterplatte 200 beschrieben. Für eine Leiterplatte 100 gemäß Figur 2 gilt das Analoge. Die Leiterbahnstrukturen im Bereich der Auswerteschaltung 260 wurden dabei nur insoweit dargestellt, wie sie zur Erläuterung des Aufbaus des erfindungsgemäßen Sensors notwendig sind. Einzelheiten der Auswerteschaltung sind in Figur 6 dargestellt und werden an entsprechender Stelle beschrieben.

Die Empfangsleiterschleifen 112 und 114 bzw. 212 und 214 auf der Leiterplatte 200 ersetzen die bei Kompensationssensoren üblichen Empfangsspulen. Die unmittelbare Konsequenz des Einsatzes von Leiterbahnen im Empfangssystem des Sensors ist die, dass die mögliche Anzahl von Leiterschleifen im Empfangspfad nicht mehr einige tausend beträgt, sondern mit realistisch 10 oder maximal 20 Windungen drastisch geringer ausfallen muss. Im engeren Sinn ist es für diese Leitergeometrien im Frequenzbereich bis 100 kHz somit nicht mehr sinnvoll von "Spulen" im herkömmlichen Sinn zu sprechen, so dass hier im verallgemeinerten Sinne von Empfangsleiterschleifen oder Empfangsleiterstrukturen die Rede ist. Beispielsweise beträgt die Induktivität eines Ensembles aus Leiterschleifen mit 40 mm Durchmesser bei 11 Windungen nur rund 10 µH. Bei einer realistischen Arbeitsfrequenz von 5 kHz ergibt sich somit eine Impedanz von nur rund 0.3 Ohm, welche im Vergleich zum ohmschen Widerstand der Leiterstruktur von rund 10 Ohm fast vernachlässigbar ist.

Ebenfalls als Leiterbahnstruktur dieser Leiterplatte 200 realisiert sind kammartige Leiterstrukturen 242, die eine Abschirmelektrode 244 bilden, welche für eine elektrische Abschirmung zwischen den Empfangsleiterschleifen 112 und 114 bzw. 212 und 214 einerseits und der Sendespule 116 bzw. 216 andererseits sorgt, indem sie auf Massepotential gelegt werden. Diese Strukturen verursachen keinerlei Mehrkosten bei der Fertigung des erfindungsgemäßen Sensors. Insbesondere können bei der vorteilhaften planaren Wickelgeometrie auch flächige Abschirmstrukturen ausreichend gute Ergebnisse liefern.

Bei den Abschirmleitungen ist allerdings darauf zu achten, dass sich innerhalb der Abschirmgeometrie keine Stromschleifen bilden. Es ist daher vorteilhaft, Mäander- oder Kamm-Strukturen aus möglichst dünnen Einzelleitern zu verwenden, die im mathematischen Sinn eine einfach zusammenhängende Fläche bilden.

Die Sendespule 116 bzw. 216 ist in Figur 4 nicht dargestellt, da diese in einer zur Ebene der Leiterplatte 200, höhenversetzten Ebene angeordnet ist. Besonders vorteilhaft ist es, wie bereits beschrieben, wenn die Sendespule 116 bzw. 216 auf einem Wickelkörper gefertigt wird, der anschließend auf die Leiterplatte 200 aufgelötet wird. Die Wicklungen der Sendespule befinden sich somit in einer bestimmten, vordefinierten Höhe oberhalb der Leiterplattenebene. In besonders vorteilhafter Weise wird die Erregerspule elektrisch über in ein Spritzgussteil eingelassene Kontaktstifte mit der Leiterplatte 200 kontaktiert, indem die Kontaktstifte in dafür vorgesehene Bohrungen auf der Leiterplatte des Sensors verlötet werden. Um eine stabile mechanische Kontaktierung zu ermöglichen, ist es hilfreich, mehr als die zwei elektrisch benötigten Kontaktstifte zu verwenden, beispielsweise indem ein oder zwei blinde, d. h. elektrisch nicht kontaktierte Pins zusätzlich hinzugefügt werden. Auf diese Art und Weise kann die Erregerspule durch den Lötprozess auch mechanisch präzise fixiert werden.

Des weiteren sind auf der Leiterplatte 200 elektrische Schaltmittel 240 vorgesehen, die beispielsweise als Transistoren, insbesondere FET-Schalter ausgebildet sein können und die es ermöglichen, die Geometrie des Empfangsleiterschleifensystems zu variieren, indem weitere Leiterschleifen 241 zu den Empfangsleitern 112 und 114 bzw. 212 und 214 hinzu oder abgeschaltet werden. Dieses Prinzip beruht darauf, dass die ursprünglichen Empfangsleiterschleifen durch eine oder mehrere zusätzlichen Leiterschleifen 241 oder auch nur durch Bruchteilen von diesen ergänzt bzw. um diese reduziert werden. Zur Durchführung dieser Variation der effektiven "Windungszahl" des Empfangsleiterschleifensystems sind die Schaltmittel 240 vorgesehen, die in entsprechenden Abgleichprozessen induktive Kompensationsmodule in Form von Leiterschleifen 241 bzw. Bruchteilen solcher Leiterschleifen dazu- oder wegschalten. Bei geeignetem Design der Leiterschleifen der Empfangssystems werden in diesen Leiterschleifenanteilen 241 Spannungen induziert, welche die Fehlspannungen im Detektor, welche beispielsweise aufgrund von Fertigungstoleranzen des Wickelkörpers der Erregerspule entstehen können, gerade kompensieren.

Im Vergleich mit Abgleichverfahren, welche auf der Erregerseite des Detektors arbeiten, ist die beanspruchte, schaltungstechnische Realisierung auf der Empfangsseite wesentlich einfacher und preisgünstiger, da beispielsweise vergleichsweise hochohmige Schaltmittel eingesetzt werden können, da im Empfangspfad im Vergleich zur Erregerspule nur verschwindend geringe Ströme fließen.

Des weiteren sind auf der gemeinsamen Leiterplatte 200 zudem Kompensationswindungen 232 der Empfangsleiterschleifensysteme 112 und 114 bzw. 212 und 214 angeordnet. Diese Kompensationswindungen 232 sind ebenfalls als Leiterbahnen bzw. Leitungsstrulcturen der Leiterplatte 200 ausgebildet. Dabei werden Anzahl und Position der jeweiligen Kompensationswindungen so dimensioniert, dass die Abhängigkeit der induzierten Spannung im Empfangsleitersystem 112 und 114 bzw. 212 und 214 von einer Fehlpositionierung der Erregerspule 116 bzw. 216 in der Höhe, d.h. in Z-Richtung, möglichst genau kompensiert wird. Eine fertigungsbedingte, geringfügige Fehlpositionierung der Erregerspule in Z-Richtung wirkt sich auf die in den Empfangsleiterschleifen in der Summe induzierte Spannung somit nicht mehr aus.

Bei der erfindungsgemäßen Detektorgeometrie ergibt sich eine deutlich reduzierte Toleranzempfmdlichkeit bezüglich der Positionierung der Erregerspule in ihrer Höhe (Z-Richtung) über der Ebene 126 der Empfangsspulen. Zusätzlich zu den Empfangs-Leiterschleifen des Empfängers im Außenbereich der Sendespule werden hierbei direkt unter der höhenversetzt angeordneten Sende- bzw. Erregerspule die Kompensationswindungen ausgebildet.

Auf der Leiterplatte 200, welche die Empfangsleiterschleifensysteme 112 und 114 bzw. 212 und 214 trägt und bildet, sind zudem die Komponenten für die Ansteuerung der Spule 116, bzw. 216 des Sensors, sowie für die Auswertung und Aufarbeitung des Messsignals integriert. So ist beispielsweise ein Shuntwiderstand 246 vorgesehen, der es, in noch zu beschreibender Weise ermöglicht, den Strom im Erregerzweig des Sensors zu messen und somit eine möglicherweise auftretende Drift in der Elektronik des erfindungsgemäßen Sensors detektieren kann. Bei Kenntnis von Strom und Phasenlage des Stroms im Erregerzweig ist es daher möglich, beispielsweise eine Verringerung der Messamplitude, welche dadurch hervorgerufen wird, dass der Strom im Erregersignal durch eine Erhöhung des Kupferwiderstands der Erregerspule mit der Temperatur sinkt, rechnerisch zu kompensieren.

Ebenso ist es möglich, auf diesem Wege eine Temperaturmessung durchzuführen, soweit die Schaltung im Erregerzweig so ausgelegt ist, dass einzig der Kupferwiderstand einer signifikanten Temperaturdrift unterworfen ist.

Aufgrund des hohen Verstärkungsfaktors der Auswerteschaltung reichen sehr geringe Spannungsamplituden am Shuntwiderstand 246 aus, so dass auch dieser vorteilhaft durch eine kurze Mäanderstruktur aus beispielsweise Kupferleiterzügen auf der Platine 200 gebildet werden kann und auf diese Weise ein weiteres, zusätzliches und separates Bauelement vermieden wird. In der Praxis reichen rund 1-2cm an Leiterstruktur für diese Aufgabe aus.

Des weiteren sind auf der Leiterplatte 200 u.a. auch noch vier Schaltelemente 248 realisiert, die verschiedene Eingangssignale auf den Eingang einer Verstärkerstufe der Auswerteschaltung aufschalten können. Die Funktionsweise dieser Schaltelemente 248 wird im Zusammenhang mit Figur 6 beschrieben.

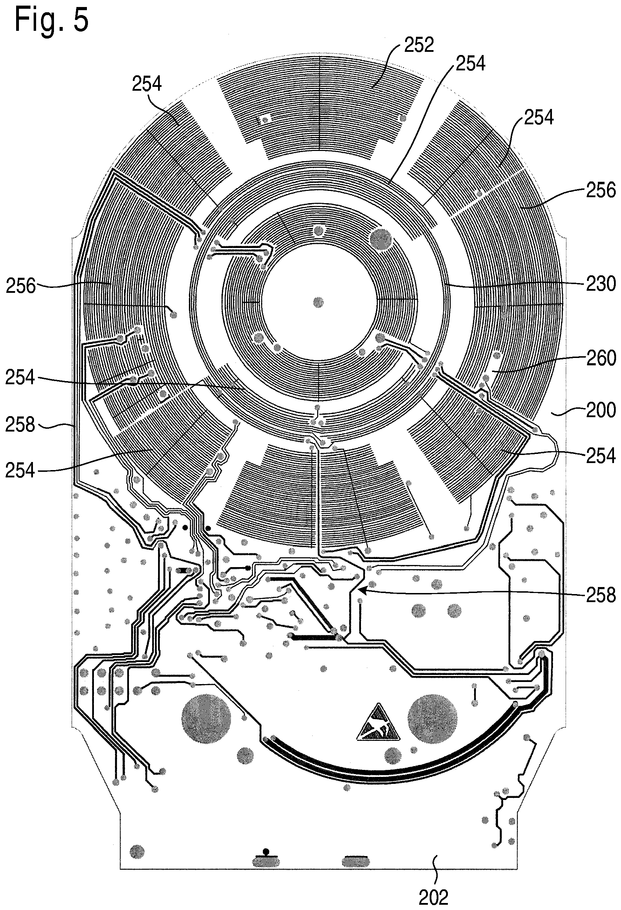

Figur 5 zeigt die Unterseite 202 der Leiterplatte 200 aus Figur 4. Auf der Unterseite der Leiterplatte 200 sind - wie im Zusammenhang mit Figur 3 beschrieben -Kompensationswindungen 230 der Empfangsleiterschleifen 112 und 114 bzw. 212 und 214 des erfindungsgemäßen Sensors ebenfalls in Form von Leiterbahnstrukturen ausgebildet.

Darüber hinaus zeigt das Ausführungsbeispiel des erfindungsgemäßen Sensors gemäß Figur 4 und 5 weitere Sensoren, die ebenfalls auf der Leiterplatte 100 und in vorteilhafter Weise insbesondere ebenfalls als Leiterstrukturen dieser Leiterplatte 100 realisiert sind. So bilden die Leiterstrukturen 250 beispielsweise einen 50-Hz AC-Sensor, der als passiver Sensor die Detektion von stromdurchflossenen Leitungselementen ermöglicht.

Die Erfindung ermöglicht es, einen kostengünstigen Sensor zu realisieren, welcher möglichst viele kostenintensive Bauteile und Geräteelemente dadurch überflüssig macht, dass die Leiterplatte des Sensors nicht nur als Träger für elektronischen Schaltungen eingesetzt wird, sondern als Funktionsteil, auf dem die entsprechenden Elemente ausgebildet sind, integraler Bestandteil des Sensors ist. So bilden die Leiterbahnstrukturen 252, 254 und 256 Elektroden eines "Studfmders", der in vorteilhafter Weise die Suche von beispielsweise Holzmaterial, welches in oder hinter einer Wand verborgen ist, mit dem erfindungsgemäßen Messgerät ermöglicht. Dabei bilden die Leiterbahnstrukturen 252 den Empfänger und die Strukturen 254 bzw. 256 die Erreger bzw. Sender für den im erfindungsgemäßen Sensor integrierten Holzsucher.

Über entsprechende Leiterbahnen 258 und Kontaktierungen 260 auf der Leiterplatte 100 sind die einzelnen Elektroden des erfindungsgemäßen Sensors mit der Auswerteschaltung 160 verbunden.

Das erfindungsgemäße Verfahren zur Auswertung der Messsignal der beanspruchten Vorrichtung ermöglicht es, die verschiedenen Sensoren sowohl parallel, quasi-parallel, als auch seriell zu nutzen. Dabei wird bei der quasi-parallelen Betriebsart sehr schnell zwischen einzelnen Sensoren umgeschaltet und die entsprechenden Detektionssignale generiert, gemessen und ausgewertet, bzw. zur Auswertung gegebenenfalls zwischengespeichert. Hier kann ebenfalls zwischen einer automatischen und einer vom Benutzer vorgegebenen Auswahl der Sensoren gewählt werden.

Nachfolgend werden spezifische schaltungstechnische Lösungen des erfindungsgemäßen Sensors vorgestellt. Verwendet man empfangsseitig anstelle der im Stand der Technik üblichen, gewickelten Spulen nunmehr erfindungsgemäß Leiterbahnen einer Platine, so kann das übliche Schaltungsverfahren, bei dem sowohl sende- als auch empfangsseitig ein Schwingkreis als Anpassungsschaltung vorgesehen ist, nicht mehr verwendet werden. Hintergrund ist hierbei einerseits, dass, sofern man die Empfangsleiterschleifen als Spule betrachtet und eine Kennziffer für deren Güte errechnet, sich Werte in der Größenordnung von Q=0.03 ergeben würden. Die extrem geringen Induktivitäten in Kombination mit dem hohen ohmschen Kupferwiderstand sind der Grund weswegen Printspulen heutzutage typischerweise erst ab Frequenzen von etwa 100 MHz eingesetzt werden und bei Frequenzen unter 1 MHz für praktische Belange bisher keine Rolle spielen.

Ein Aufbau von Schwingkreisen mit Hilfe der Empfangs"induktivität" ist daher für die Auswerteschaltung des erfindungsgemäßen induktiven Sensors nicht zielführend. Andererseits ist es in der Praxis selbst bei verschwindendem ohmschen Widerstand nur schwer möglich, bei den für induktive Sensoren zweckmäßigen Frequenzen kleiner oder gleich 100 kHz Resonanz zu erreichen, da der Induktivitätsbelag nur in der Größenordnung von einigen 10 µH liegt. Die erforderlichen Schwingkreiskapazitäten müssten prohibitiv große Werte annehmen, die in der Praxis nicht verfügbar sind. Dies führt dazu, dass im Empfangspfad des erfindungsgemäßen Sensors bei Verzicht auf eine Empfangsspule eine Resonanzüberhöhung zur Vergrößerung der Signalspannung nicht möglich ist. Zusätzlich zur fehlenden Resonanzüberhöhung sinkt auch die Signalstärke bei Verwendung von Printleiterschleifen im Vergleich zu gewickelten Detektorspulen mit beispielsweise 2000-6000 Windungen, wie sie in der EP 102989 A1 vorgeschlagen werden, da auf der Leiterplatte Printleiterschleifen mit deutlich mehr als 10-20 Windungen nur mit erhöhtem Aufwand realisiert werden können.

Eine erste Konsequenz des Verzichts auf einen Schwingkreis zur Auswertung des Messsignals des erfindungsgemäßen Sensors besteht darin, dass die zu detektierenden Signalamplituden erheblich geringer sind. Die zu verstärkenden Signalamplituden liegen beispielsweise im Fall von zu ortenden, dünnen Kupferobjekten in der Größenordnung von nur wenigen 10 nV. Bei Spannungen in dieser Größenordnung und den notwendigen Verstärkungsfaktoren der Auswerteschaltung des erfindungsgemäßen Sensors von rund 100.000 kann somit im Allgemeinen ein Überkoppeln von Störsignalen aus der Spannungsversorgung der Verstärkerschaltung auf den Signalpfad des Sensors nicht mehr oder nur mit extremem Aufwand vermieden werden.

Bei den geringen Signalamplituden ist es weiterhin erforderlich, Verstärker mit einem besonders niedrigen Spannungsrauschen einzusetzen. Insbesondere erscheinen Operationsverstärker mit bipolarer Eingangsstufe hier als besonders geeignet, da die Quellenimpedanz der Empfangswindungen mit rund 30 Ohm sehr niedrig liegt.

Figur 6 zeigt eine erfindungsgemäße Schaltung zur Auswertung und Aufbereitung der Signalspannungen, welche in Summe in den einzelnen Empfangswindungen des erfindungsgemäßen Sensors induziert werden.

Die Induktivität 262 bezeichnet dabei die konventionell aus Draht gewickelte Erregerspule 116 bzw. 216 (vergleiche Figur 2 und 3), welche mit der Kapazität 264 einen Schwingkreis bildet und an die über einen Widerstand 266 eine Spannungsquelle 268 angeschlossen wird. Die Induktivität 270 bezeichnet in Figur 6 die durch die Leiterzüge 113 und 115 bzw. 213 und 215 auf der Leiterplatte 200 ausgebildete Induktivität der Empfangsleiterschleifen 112,114 bzw. 212,214, an der das schwache Messsignal in Form der induzierten Spannung abgegriffen werden kann.

Die Auswerteschaltung besteht im Ausführungsbeispiel gemäß Figur 6 u.a. aus einem zweistufigen Verstärker mit zwei Operationsverstärkern 272 bzw. 274, an deren Ausgang z.B. ein Analog-Digital-Konverter (ADC) 276 angeschlossen sein kann. Die erste, besonders rauscharm ausgelegte Verstärkerstufe 272 verstärkt das Messsignal zunächst, welches anschließend in einer zweiten Stufe 274 mit Bandpasscharakteristik (z.B. für eine Digitalisierung in einem ADC) aufbereitet wird. Zu beachten ist, dass der Operationsverstärker 272 über eine bipolare Eingangsstufe verfügt und im Rückkoppelpfad der ersten Verstärkerstufe niederohmige Widerstände verwendet werden. Die zweite Verstärkerstufe stellt sicher, dass höhere Harmonische des Erregerfeldes aus dem Messsignal herausgefiltert werden.

Vor der ersten Verstärkerstufe 272 befinden sich eine Reihe von Schaltern 248, welche verschiedene Eingangssignale 278 auf den Eingang 280 der Verstärkerstufe 272 aufschalten können. So kann beispielsweise im Messbetrieb des erfindungsgemäßen Sensors durch Schließen eines Schalters 2482, die in der Detektorspule 270 induzierte Spannung auf den Eingang der Verstärkerstufe 272 aufgeschaltet werden.

Aufgrund der geringen Signalpegel ist es in der Praxis jedoch nicht auszuschließen, dass innerhalb des Verstärkers ein Störsignal generiert wird, selbst wenn im Empfangssystem 270 keine Spannung induziert wird. Mögliche Quellen eines solchen Störsignals sind, wie bereits angedeutet, beispielsweise Verkopplungen zwischen Störsignalen der Spannungsversorgung der Operationsverstärker und dem Eingang der Verstärkerstufen.

Um diese Störsignale vermessen zu können und von den eigentlichen Messsignalen abziehen zu können, ist es mit dem erfindungsgemäßen Verfahren zur Auswertung der Messsignale möglich, alternativ nicht Schalter 2482 zu öffnen, sondern den Eingang 280 des Verstärkers 272 mit Hilfe des Schalters 2481 direkt auf Massepotential zu legen. Die in dieser Schalterkonfiguration zu vermessenden Störspannungen können von den in Messkonfiguration (Schalter 2482 dann geschlossen) bestimmten Spannungen subtrahiert werden.

Entscheidend für die Messgenauigkeit bei Messsignalen in der Größenordnung von nur einigen nV ist eine effektive Unterdrückung des Rauschhintergrundes, insbesondere des Rauschens im Verstärker. Der Operationsverstärker aus Fig. 6 verfügt daher zumindest in der ersten Verstärkerstufe über einen bipolaren Eingangskreis. Die erforderliche Rauschunterdrückung entspricht einer schmalbandigen Filterung des Messsignals. Geht man von einem eingangsbezogenen Widerstandsrauschen im Verstärker in der Größenordnung von 4 nV/√Hz aus, so ergibt sich, dass das Rauschfilter eine Bandbreite von nur wenigen 10 Hz haben müsste. Derartige schmalbandige Filter sind in analoger Technik nur mit großem Aufwand und hohen Kosten zu realisieren.

In vorteilhafter Weise ist daher für den erfindungsgemäßen induktiven Sensor mit Empfangsleiterschleifensystem im Print-Layout als Empfangsteil ein Auswerteverfahren mit einer digitalen Rauschunterdrückung realisiert worden. Bei einer derartigen Filterung wird das Messsignal am Ausgang des Messverstärkers zunächst mittels eines Analog-DigitalWandlers (ADC) synchron digitalisiert und mit einer nachgeschalteten digitalen Schaltung oder einem Mikroprozessor digital weiterverarbeitet. Zweckmäßigerweise generiert dieser digitale Schaltungsteil auch die Treiberspannung, welche die Erregerspule ansteuert. Besonders zweckmäßig ist es, das Messsignal mit der vier oder achtfachen Frequenz (z.B. mit ∼20 kHz) des Erregermagnetfelds (z.B. ∼5 kHz) zu digitalisieren. Es ist dann möglich, die am Ausgang der Verstärkerstufe im Empfangszweig anliegende Spannung phasensynchron mit der Erregerspannung zu digitalisieren und auf diese Weise rechnerisch eine digitale Rauschfilterung zu erzielen. Auf diesem Weg sind effektive Rauschbandbreiten in der Größenordnung von wenigen Hertz ohne hohe Kosten und ohne großen Aufwand möglich.

Um die Drift der Schaltung und insbesondere der Sendespule, welche sich beispielsweise dadurch ergibt, dass der Kupferwiderstand der Erregerspule sich über die Temperatur verändert, kompensieren zu können, enthält die Schaltung zwei zusätzliche Schalter 2483 und 2484, welche es gestatten, an zwei Seiten eines Shuntwiderstandes 246 eine Spannung V1 bzw. V2 abzugreifen, welche proportional zum im Erregerschwingkreis fließenden Strom ist. Die Verwendung von zwei Abgriffpunkten 282 (für V2) und 284 für (für V1) ist vorteilhaft, da sich zwischen dem Massepotential des Erregerkreises und dem Massepotential der Empfängerschaltung geringfügige Unterschiede ergeben können, welche durchaus in der Größenordnung des Messsignals liegen können. Bei Kenntnis von Strom und Phasenlage des Stroms im Erregerzweig ist es aber möglich, beispielsweise eine Verringerung der Messamplitude rechnerisch zu kompensieren. Eine solche Verringerung der Messamplitude kann u.a. dadurch hervorgerufen werden, dass der Strom im Erregersignal aufgrund einer Erhöhung des Kupferwiderstands der Erreger- oder Sendespule mit der Temperatur sinkt.

Aufgrund des hohen Verstärkungsfaktors der Auswerteschaltung reichen sehr geringe Spannungsamplituden am Shuntwiderstand 246 aus, so dass auch dieser vorteilhaft durch eine kurze Mäanderstruktur aus Kupferleiterzügen auf der Platine gebildet werden kann und auf diese Weise ein zusätzliches separates Bauelement vermieden wird. In der Praxis reichen rund 1-2 cm an Leiterstruktur für diese Aufgabe aus.

In der Praxis ist es zweckmäßig, auch die Schaltmittel 2181 bis 2484 nicht durch mechanische Schalter zu realisieren, sondern an deren Stelle Relais oder Halbleiterschalter zu verwenden. Insbesondere erscheinen Feldeffekttransistoren als das Schaltmittel der Wahl. Hierbei ist es weiterhin möglich, die Schalterstellung durch einen Microcontroller zu steuern und beispielsweise zyklisch einen automatischen Abgleich des Übersprechsignals vorzunehmen, welches durch parasitäre Verkopplung zwischen der Versorgung der Operationsverstärker und dem Eingang der Auswerteschaltung hervorgerufen wird.

Wenn für die Vermessung von Mess- (entsprechend Schalter 2482) Kalibrier- (Schalter 2483 und 2484) und Störsignalen (Schalter 2481) derselbe Analogverstärker 272 bzw. 274 verwendet wird, hat dies zusätzlich den Vorteil, dass Drifteffekte und Exemplarstreuungen innerhalb der Verstärkerbaugruppen sich auf die verschiedenen Messsignale in identischer Weise auswirken. Es ist somit mit dem erfindungsgemäßen Verfahren möglich, eine Langzeitdrift der Verstärkerbaugruppe rechnerisch zu kompensieren.

Um die kapazitive Kopplung effektiv unterdrücken zu können, ist es möglich, auf der Leiterplatte 200 zwischen der gewickelten Erregerspule und den Empfangsleiterstrukturen Abschirmelemente vorzusehen, die vorteilhafter Weise ebenfalls als Leiterbahnstrukturen 242 ausgebildet sind, und auf Massepotential gelegt werden. Diese Strukturen verursachen bei der Fertigung keinerlei Mehrkosten. Insbesondere können bei der erfindungsgemäßen planaren Wickelgeometrie auch flächige Abschirmstrukturen gute Ergebnisse liefern.

Beim Verlegen, bzw. Ausbilden der Abschirmleitungen 242 bzw. 244 ist allerdings darauf zu achten, dass sich innerhalb der Abschirmgeometrie keine Stromschleifen bilden können. Es ist daher sinnvoll, Mäander- oder Kamm-Strukturen aus möglichst dünnen Einzelleitern zu verwenden, die im mathematischen Sinn eine einfach zusammenhängende Fläche bilden. Das Gleiche gilt für die auf der Unterseite angeordneten Strukturen für die passiven und aktiven kapazitiven Sensoren (256, 254, 252).

Der erfindungsgemäße Sensor kann in vorteilhafter Weise in ein Messgerät integriert werden. Dabei kann ein solches Messgerät insbesondere als ein handgehaltenes Metallortungsgerät ausgebildet sein oder aber die Metallortungsfähigkeit über den erfindungsgemäßen Sensor als eine Zusatzfunktion beinhalten.

Darüber hinaus ist es auch möglich und vorteilhaft, den erfindungsgemäßen Sensor auch in eine Werkzeugmaschine, beispielsweise in ein Bohrwerkzeug zu integrieren, um einem Anwender ein sicheres Arbeiten mit dieser Maschine zu ermöglichen.

Die Erfindung ermöglicht es, einen kostengünstigen Sensor zu realisieren, welcher möglichst viele der kostenintensiven Bauteile und Geräteelemente dadurch überflüssig macht, dass eine Leiterplatte des Sensors nicht nur als Trägermaterial für die elektronischen Schaltungen eingesetzt wird, sondern als Funktionsteil integraler Bestandteil des Sensors ist. Der erfindungsgemäße Sensor zur Ortung metallischer Objekte erfordert lediglich eine einzelne Spule. Dies wird insbesondere erreicht, durch das Ersetzen der typischerweise gewickelten Empfangsspulen, wie sie aus dem Stand der Technik bekannt sind, durch Leiterzüge auf einer Leiterplatte der Auswerteschaltung des Sensors, sowie die Ausbildung von geeigneten Leiterzügen auf der Leiterplatte, die der Abschirmung von Erreger- bzw. Sendespule und Empfangsleiterschleifen dienen und zu einer Unterdrückung der kapazitiven Verkopplung zwischen Sende- und Empfangspfad des Sensors führen.

Darüber hinaus ist es möglich, einen Shuntwiderstand wiederum direkt durch eine Leiterbahnstruktur auf der Leiterplatte des Sensors auszubilden, wobei der Shuntwiderstand es gestattet, den Strom im Erreger-zweig des Sensors zu vermessen und so eine Temperaturdrift des Stroms in der Erregerspule zu bestimmen und zu kompensieren.

Durch die erfindungsgemäße Ausgestaltung der Sensorgeometrie liefert der beanspruchte Sensor zur Ortung metallischer Objekte auch ohne einen regelmäßigen, vor einer jeden Messung durchzuführenden Kalibrierprozess gute Messergebnisse.

Der erfindungsgemäße Sensor zur Ortung metallischer Objekte ist nicht auf die in den Figuren dargestellten Ausführungsbeispiele beschränkt.
Der erfindungsgemäße Sensor ist nicht auf die Verwendung einer einzelnen Sendespule beschränkt. Das Verfahren lässt sich unmittelbar auch auf Kompensationsgeometrien übertragen, welche mehr als eine Erregerspule einsetzen, beispielsweise, um so zusätzlich auch die räumliche Lage eines metallischen Objektes bestimmen zu können.

Insbesondere ist es mit den hier beschriebenen Verfahren auch möglich, für Basiskonfigurationen eines Kompensationssensors, welche von Figur 1 abweichen, Lösungen zu finden, sofern die Geometrie und Lage der zumindest einen ersetzten Empfangsspule näherungsweise die für den Einsatz einer Leiterplatte erforderliche flächige Geometrie gestatten. Die Erfindung und insbesondere die Verwendung von Leiterbahnstrukturen einer Leiterplatte als Empfangsleiterschleifensystem ist in keiner weise auf den Typ des Kompensationssensors beschränkt.

Insbesondere ist es auch denkbar, im Empfangspfad eine Kombination von leiterplattengebundenen Empfangsleiterschleifen und Empfangswindungen innerhalb einer konventionell gewickelten Spule zu verwenden. Dies gilt insbesondere, wenn die leiterplattengebundenen Empfangsleiterschleifen auch wirklich maßgeblich zu den von Metallobjekten vermittelten Induktionsspannungen beitragen. Eine Konsequenz daraus wäre, dass auch die konventionell gewickelte Ergänzungsspule eine ungewöhnlich geringe Anzahl an Windungen aufweisen müsste. Der potentielle Vorteil einer derartigen Kombinationslösung im Empfangspfad besteht unter anderem darin, dass auch hier die beschriebenen Verfahren zur Reduzierung der Anforderungen an die Positionier- und Fertigungstoleranz der gewickelten Spulen durch geeignet ausgeformte Kompensationsschleifen auf der Leiterplatte gelingen kann.

Weiterhin ist es denkbar, für den Sensor nicht eine zwei- sondern eine mehrlagige Leiterplatte einzusetzen, beispielsweise um die mögliche Anzahl von Windungen im Empfangspfad zu erhöhen, die Empfangsleiterschleifen oder die Positioniertoleranz-Kompensationsschleifen ganz oder teilweise in Innenlagen zu verschieben, Bauelemente oberhalb der Empfangsleiterschleifen zu platzieren oder um die kapazitive Kopplung von Erreger und Empfängerzweig noch effektiver unterdrücken zu können.

Insbesondere ist der erfindungsgemäße Sensor nicht beschränkt auf die Verwendung von kreisförmigen Spulen oder Leiterschleifensystemen. Abweichend von den in den Figuren dargestellten Empfangsleiterschleifensystemen kann jedes Leiterschleifensystem oder einzelne Leiterschleifen eine vom Kreis oder Kreisbogen abweichende Form haben und aus einer oder auch mehreren Windungen bestehen.

## Patentansprüche

1. Sensor zur Ortung metallischer Objekte, insbesondere ein Metallsensor für Bauwerkstoffe, mit zumindest einer Sendespule (116,216) und mindestens einem Empfangs-Leiterschleifensystem (112,212), welche induktiv miteinander gekoppelt sind, wobei das Empfangs-Leiterschleifensystem (112,212) durch Leiterstrukturen auf einer Leiterplatte (100,200) gebildet ist, **dadurch gekennzeichnet, dass** ein in Reihe mit mindestens einer Sendespule (116,216) geschalteter Shuntwiderstand (246) vorgesehen ist, der als Leiterbahnstruktur auf der Leiterplatte (100,200) ausgebildet ist, ferner **gekennzeichnet durch** eine Auswertungsschaltung (260), welche über Schaltmittel (248) sowohl mit dem Shuntwiderstand (246) als auch mit mindestens einem Empfangs-Leiterschleifensystem (112,114,212,214) verbindbar ist.

2. Sensor nach Anspruch 1, **dadurch gekennzeichnet, dass** ein zweites Empfangs-Leiterschleifensystem (114,214) vorgesehen ist, das koaxial zum ersten Empfangs-Leiterschleifensystem (112,212) in einer gemeinsamen ersten Ebene (126,226) mit diesem auf der Leiterplatte (100,200) angeordnet ist.

3. Sensor nach Anspruch 1 oder 2, **dadurch gekennzeichnet, dass** Magnetfelder im Frequenzbereich von unter 1 MHz genutzt werden, vorzugsweise Magnetfelder im Frequenzband von 100 Hz bis 200 kHz.

4. Sensor nach Anspruch 1, 2 oder 3, **dadurch gekennzeichnet, dass** eine elektrische Abschirmelektrode (242,244) zwischen der mindestens einen Sendespule (116,216) und mindestens einem Empfangs-Leiterschleifensystem (112,114,212,214) vorgesehen ist, wobei die elektrische Abschirmelektrode (242,244) auf der Leiterplatte (100,200) ausgebildet ist.

5. Sensor nach Anspruch 3 oder 4, **dadurch gekennzeichnet, dass** als Schaltmittel (248) Halbleiterschalter, insbesondere Feldeffekttransistoren, zum Einsatz kommen, wobei die Schaltmittel auf der Leiterplatte (100,200) angeordnet sind.

6. Sensor nach Anspruch 4, oder 5 **dadurch gekennzeichnet, dass** die Auswertungsschaltung (260) zumindest eine bipolare Eingangsstufe aufweist.

7. Sensor nach einem der vorhergehenden Ansprüche, **dadurch gekennzeichnet, dass** mindestens eine Sendespule (116,216) zur Ebene (126,226) der Leiterplatte (100,200) höhenversetzt angeordnet ist.

8. Sensor nach einem der vorhergehenden Ansprüche, **dadurch gekennzeichnet, dass** mindestens eine Sendespule (116,216) auf einem Wickelkörper aufgebracht ist, wobei der Wickelkörper auf der Leiterplatte (100,200) befestigt ist.

9. Sensor nach Anspruch 7 oder 8, **dadurch gekennzeichnet, dass** in Nähe der mindestens einen Sendespule (116,216) zusätzliche Kompensations-Leiterschleifen (130,132,230,232) mindestens eines Empfangs-Leiterschleifensystems (112,114, 212,214) auf der Leiterplatte (100,200) ausgebildet sind.

10. Sensor nach Anspruch 7, 8 oder 9, **dadurch gekennzeichnet, dass** unterhalb der mindestens einen Sendespule (116,216) zusätzliche Kompensations-Leiterschleifen (130,132,230,232) mindestens eines Empfangs-Leiterschleifensystems (112,114, 212,214) auf der Leiterplatte (100,200) ausgebildet sind.

11. Sensor nach Anspruch 9 oder 10, **dadurch gekennzeichnet, dass** die Kompensations-Leiterschleifen (130,132,230,232) als Leiterstrukturen auf der Leiterplatte (100,200) ausgebildet sind.

12. Sensor nach Anspruch 11, **dadurch gekennzeichnet, dass** die Kompensations-Leiterschleifen (130,132,230,232) auf zwei gegenüberliegenden Seitenflächen (201,202) der Leiterplatte (200) ausgebildet sind.

13. Sensor nach Anspruch 9 oder 11, **dadurch gekennzeichnet, dass** die Kompensations-Leiterschleifen (130,132,230,232) als Leiterstrukturen in übereinander liegenden inneren Lagen der mindestens zweilagigen Leiterplatte ausgebildet sind.

14. Sensor nach Anspruch 12 oder 13, **dadurch gekennzeichnet, dass** die Kompensations-Leiterschleifen (130,132,230,232) bei nahezu gleicher Geometrie entgegengesetzte Orientierungen aufweisen.

15. Sensor nach einem der vorhergehenden Ansprüche, **dadurch gekennzeichnet, dass** mindestens eine Abgleich-Leiterschleife (241) auf der Leiterplatte (100,200) vorgesehen ist, welche mittels Schaltmitteln (240) mit dem Empfangs-Leiterschleifensystem (112,114,212,214) verbindbar ist.

16. Sensor nach Anspruch 15, **dadurch gekennzeichnet, dass** als Schaltmittel (240) Halbleiterschalter, insbesondere Feldeffekttransistoren, zum Einsatz kommen.

17. Sensor nach einem der vorhergehenden Ansprüche, **dadurch gekennzeichnet, dass** das Empfangs-Leiterschleifensystem (112,114,212,214) durch mindestens eine konventionell gewickelte Empfangsspule ergänzt ist, wobei die Summe des Betrags der in den leiterplattengebundenen Empfangs-Leiterschleifen (112,114,212,214) induzierten Spannung mindestens 25 % des Spannungspegels beträgt, welcher in der oder den konventionell gewickelten Empfangsspulen induziert wird.

18. Verfahren zur Auswertung des Messsignals eines Sensors gemäß zumindest einem der Ansprüche 1 bis 17, **dadurch gekennzeichnet, dass** die Messignale digitalisiert werden.

19. Verfahren nach Anspruch 18, **dadurch gekennzeichnet, dass** eine schmalbandige, digitale Filterung zur Reduzierung der Rauschbandbreite mittels digitaler Generierung eines Erregersignals der Frequenz f und phasensynchroner Analog-Digital-Konvertierung eines Ausgangssignals eines Messverstärkers der Auswerteschaltung des Sensors durchgeführt wird.

20. Verfahren nach Anspruch 19, **dadurch gekennzeichnet, dass** die phasensynchrone Analog-Digital-Konvertierung des Ausgangssignals des Messverstärkers mit einer Frequenz f_{d} = 4 n f, also der vierfachen Frequenz 4f des Erregerfeldes oder einem ganzzahligen Vielfachen n dieser Frequenz erfolgt.

21. Messgerät, insbesondere ein handgehaltenes Ortungsgerät, mit zumindest einem Sensor nach einem oder mehreren der Ansprüche 1 bis 16.

22. Werkzeuggerät, insbesondere ein Bohr- oder Meißelwerkzeug, mit einem Sensor nach einem oder mehreren der Ansprüche 1 bis 16.

## Claims

1. Sensor for locating metallic objects, in particular a metal sensor for construction materials, comprising at least one transmission coil (116, 216) and at least one reception conductor loop system (112, 212), which are inductively coupled to one another, wherein the reception conductor loop system (112, 212) is formed by conductor structures on a printed circuit board (100, 200), **characterized in that** a shunt resistor (246) connected in series with at least one transmission coil (116, 216) is provided, said shunt resistor being embodied as a conductor track structure on the printed circuit board (100, 200), furthermore **characterized by** an evaluation circuit (260), which is connectable via switching means (248) both to the shunt resistor (246) and to at least one reception conductor loop system (112, 114, 212, 214).

2. Sensor according to Claim 1, **characterized in that** a second reception conductor loop system (114, 214) is provided, which is arranged coaxially with respect to the first reception conductor loop system (112, 212) in a common first plane (126, 226) with the latter on the printed circuit board (100, 200).

3. Sensor according to Claim 1 or 2, **characterized in that** magnetic fields in the frequency range of below 1 MHz are used, preferably magnetic fields in the frequency band of 100 Hz to 200 kHz.

4. Sensor according to Claim 1, 2 or 3, **characterized in that** provision is made of an electrical shielding electrode (242, 244) between the at least one transmission coil (116, 216) and at least one reception conductor loop system (112, 114, 212, 214), wherein the electrical shielding electrode (242, 244) is formed on the printed circuit board (100, 200).

5. Sensor according to Claim 3 or 4, **characterized in that** semiconductor switches, in particular field effect transistors, are used as switching means (248), wherein the switching means are arranged on the printed circuit board (100, 200).

6. Sensor according to Claim 4 or 5, **characterized in that** the evaluation circuit (260) has at least one bipolar input stage.

7. Sensor according to any of the preceding claims, **characterized in that** at least one transmission coil (116, 216) is arranged in a height-offset manner with respect to the plane (126, 226) of the printed circuit board (100, 200).

8. Sensor according to any of the preceding claims, **characterized in that** at least one transmission coil (116, 216) is applied on a winding body, wherein the winding body is secured on the printed circuit board (100, 200).

9. Sensor according to Claim 7 or 8, **characterized in that** in the vicinity of the at least one transmission coil (116, 216) additional compensation conductor loops (130, 132, 230, 232) of at least one reception conductor loop system (112, 114, 212, 214) are formed on the printed circuit board (100, 200).

10. Sensor according to Claim 7, 8 or 9, **characterized in that** below the at least one transmission coil (116, 216) additional compensation conductor loops (130, 132, 230, 232) of at least one reception conductor loop system (112, 114, 212, 214) are formed on the printed circuit board (100, 200).

11. Sensor according to Claim 9 or 10, **characterized in that** the compensation conductor loops (130, 132, 230, 232) are formed as conductor structures on the printed circuit board (100, 200).

12. Sensor according to Claim 11, **characterized in that** the compensation conductor loops (130, 132, 230, 232) are formed on two opposite side surfaces (201, 202) of the printed circuit board (200).

13. Sensor according to Claim 9 or 11, **characterized in that** the compensation conductor loops (130, 132, 230, 232) are formed as conductor structures in inner layers of the at least two-layered printed circuit board, said inner layers lying one above another.

14. Sensor according to Claim 12 or 13, **characterized in that** the compensation conductor loops (130, 132, 230, 232) have opposite orientations in conjunction with virtually identical geometry.

15. Sensor according to any of the preceding claims, **characterized in that** provision is made of at least one adjustment conductor loop (241) on the printed circuit board (100, 200), which is connectable to the reception conductor loop system (112, 114, 212, 214) by means of switching means (240).

16. Sensor according to Claim 15, **characterized in that** semiconductor switches, in particular field effect transistors, are used as switching means (240).

17. Sensor according to any of the preceding claims, **characterized in that** the reception conductor loop system (112, 114, 212, 214) is supplemented by at least one conventionally wound reception coil, wherein the sum of the absolute value of the voltage induced in the printed-circuit-board-bound reception conductor loops (112, 114, 212, 214) is at least 25% of the voltage level which is induced in the conventionally wound reception coil(s).

18. Method for evaluating the measurement signal of a sensor according to at least one of Claims 1 to 17, **characterized in that** the measurement signals are digitized.

19. Method according to Claim 18, **characterized in that** a narrowband, digital filtering is carried out in order to reduce the noise bandwidth by means of digital generation of an excitation signal having the frequency f and phase-synchronous analogue-to-digital conversion of an output signal of a measuring amplifier of the evaluation circuit of the sensor.

20. Method according to Claim 19, **characterized in that** the phase-synchronous analogue-to-digital conversion of the output signal of the measuring amplifier is effected with a frequency f_{d} = 4 n f, that is to say a frequency 4f four times that of the excitation field or an integral multiple n of this frequency.

21. Measuring apparatus, in particular a handheld locating apparatus, comprising at least one sensor according to one or more of Claims 1 to 16.

22. Tool apparatus, in particular a drilling or chiselling tool, comprising a sensor according to one or more of Claims 1 to 16.

## Revendications

1. Capteur destiné à localiser des objets métalliques, notamment un capteur de métal pour matériaux de construction, comportant au moins une bobine d'émission (116, 216) et au moins un système de boucles conductrices de réception (112, 212) qui sont couplés les uns aux autres par induction, dans lequel le système de boucles conductrices de réception (112, 212) est formé par des structures conductrices sur une carte de circuit imprimé (100, 200), **caractérisé en ce qu'**il est prévu une résistance de dérivation (246) connectée en série à au moins une bobine d'émission (116, 216) qui est réalisée sous la forme d'une structure de piste conductrice sur la carte de circuit imprimé (100, 200), **caractérisé en outre par** un circuit d'évaluation (260) qui peut être relié par l'intermédiaire de moyens de commutation (248) non seulement à la résistance de dérivation(246) mais aussi à au moins un système de boucles conductrices de réception (112, 114, 212, 214).

2. Capteur selon la revendication 1, **caractérisé en ce qu'**il est prévu un deuxième système de boucles conductrices de réception (114, 214) qui est disposé coaxialement par rapport au premier système de boucles conductrices de réception (112, 212), avec ce dernier, dans un premier plan commun (126, 226) sur la carte de circuit imprimé (100, 200).

3. Capteur selon la revendication 1 ou 2, **caractérisé en ce que** des champs magnétiques se situant dans une plage de fréquences inférieure à 1 MHz sont utilisés, de préférence des champs magnétiques se situant dans la bande de fréquences de 100 Hz à 200 kHz.

4. Capteur selon la revendication 1, 2 ou 3, **caractérisé en ce qu'**il est prévu une électrode de blindage électrique (242, 244) entre l'au moins une bobine d'émission (116, 216) et au moins un système de boucles conductrices de réception (112, 114, 212, 214), dans lequel l'électrode de blindage électrique (242, 244) est réalisée sur la carte de circuit imprimé (100, 200).

5. Capteur selon la revendication 3 ou 4, **caractérisé en ce que** des commutateurs à semi-conducteur, notamment des transistors à effet de champ, sont utilisés en tant que moyens de commutation (248), dans lequel les moyens de commutation sont disposés sur la carte de circuit imprimé (100, 200).

6. Capteur selon la revendication 4 ou 5, **caractérisé en ce que** le circuit d'évaluation (260) comporte au moins un étage d'entrée bipolaire.

7. Capteur selon l'une quelconque des revendications précédentes, **caractérisé en ce qu'**au moins une bobine d'émission (116, 216) est disposée de manière décalée en hauteur par rapport au plan (126, 226) de la carte de circuit imprimé (100, 200).

8. Capteur selon l'une quelconque des revendications précédentes, **caractérisé en ce qu'**au moins une bobine d'émission (116, 216) est placée sur un élément d'enroulement, dans lequel l'élément d'enroulement est fixé à la carte de circuit imprimé (100, 200).

9. Capteur selon la revendication 7 ou 8, **caractérisé en ce que** des boucles conductrices de compensation supplémentaires (130, 132, 230, 232) d'au moins un système de boucles conductrices de réception (112, 114, 212, 214) sont réalisées sur la carte de circuit imprimé (100, 200) à proximité de l'au moins une bobine d'émission (116, 216).

10. Capteur selon la revendication 7, 8 ou 9, **caractérisé en ce que** des boucles conductrices de compensation supplémentaires (130, 132, 230, 232) d'au moins un système de boucles conductrices de réception (112, 114, 212, 214) sont réalisées sur la carte de circuit imprimé (100, 200) en-dessous de l'au moins une bobine d'émission (116, 216).

11. Capteur selon la revendication 9 ou 10, **caractérisé en ce que** les boucles conductrices de compensation (130, 132, 230, 232) sont réalisées sur la carte de circuit imprimé (100, 200) sous la forme de structures conductrices.

12. Capteur selon la revendication 11, **caractérisé en ce que** les boucles conductrices de compensation (130, 132, 230, 232) sont réalisées sur deux surfaces latérales opposées (201, 202) de la carte de circuit imprimé (200).

13. Capteur selon la revendication 9 ou 11, **caractérisé en ce que** les boucles conductrices de compensation (130, 132, 230, 232) sont réalisées sous la forme de structures conductrices dans des couches internes superposées de la carte de circuit imprimé à au moins deux couches.

14. Capteur selon la revendication 12 ou 13, **caractérisé en ce que** les boucles conductrices de compensation (130, 132, 230, 232) présentent des géométries pratiquement identiques ayant des orientations opposées.

15. Capteur selon l'une quelconque des revendications précédentes, **caractérisé en ce qu'**il est prévu sur la carte de circuit imprimé (100, 200) au moins une boucle conductrice d'ajustement (241) qui peut être reliée au système de boucles conductrices de réception (112, 114, 212, 214) par l'intermédiaire de moyens de commutation (240).

16. Capteur selon la revendication 15, **caractérisé en ce que** des commutateurs à semi-conducteur, notamment des transistors à effet de champ, sont utilisés en tant que moyens de commutation (240).

17. Capteur selon l'une quelconque des revendications précédentes, **caractérisé en ce que** le système de boucles conductrices de réception (112, 114, 212, 214) est complété par au moins une bobine de réception enroulée de la manière classique, dans lequel la somme des valeurs des tensions induites dans les boucles conductrices de réception (112, 114, 212, 214) reliées à la carte de circuit imprimé est d'au moins 25 % du niveau de tension qui est induit dans la ou les bobines de réception enroulées de la manière classique.

18. Procédé pour évaluer du signal de mesure d'un capteur selon au moins l'une des revendications 1 à 17, **caractérisé en ce que** les signaux de mesure sont numérisés.

19. Procédé selon la revendication 18, **caractérisé en ce qu'**un filtrage numérique à bande étroite est effectué pour réduire la largeur de bande de bruit en générant numériquement un signal d'excitation de fréquence f et **en ce qu'**une conversion numérique à analogique synchronisée en phase d'un signal de sortie d'un amplificateur de mesure du circuit d'évaluation du capteur est effectuée.

20. Procédé selon la revendication 19, **caractérisé en ce que** la conversion numérique à analogique synchronisée en phase du signal de sortie de l'amplificateur de mesure est effectuée à une fréquence f_{d} = 4 n f, et par conséquent à une fréquence 4f quadruple du champ d'excitation ou à un multiple entier n de ladite fréquence.

21. Appareil de mesure, notamment appareil de localisation portatif, comportant au moins un capteur selon une ou plusieurs des revendications 1 à 16.

22. Appareil d'outillage, notamment outil de perçage et/ou de ciselage, comportant un capteur selon une ou plusieurs des revendications 1 à 16.
